# FASCICULE DE BREVET EUROPEEN

(11) **EP 4 214 004 B1**
(45) Date de publication et mention de la délivrance du brevet: **14.10.2026**
(21) Numéro de dépôt: 21769772.1
(22) Date de dépôt: 19.08.2021
(51) Int. Cl.: B09B 3/00, B01J 3/00, B09B 5/00, B29B 17/02, C08J 11/04, C08J 11/14, B09B 3/45, B09B 3/70, H10F 19/85

(54) **PROCÉDÉ DE TRAITEMENT DE MATÉRIAUX COMPRENANT DES COMPOSÉS ORGANIQUES PAR UN MILIEU AQUEUX DENSE SOUS PRESSION OU SOUS FORME DE VAPEUR**
VERFAHREN ZUR BEHANDLUNG VON MATERIALIEN MIT ORGANISCHEN VERBINDUNGEN MIT EINEM DICHTEN WÄSSRIGEN DRUCKMEDIUM ODER EINEM WÄSSRIGEN MEDIUM IN FORM VON DAMPF
METHOD FOR TREATING MATERIALS COMPRISING ORGANIC COMPOUNDS WITH A DENSE PRESSURISED AQUEOUS MEDIUM OR AN AQUEOUS MEDIUM IN THE FORM OF STEAM

(30) Priorité: 16.09.2020 FR 2009380
(43) Date de publication de la demande: 26.07.2023
(73) Titulaire: Commissariat à l'Energie Atomique et aux Energies Alternatives, 75015 Paris (FR)
(72) Inventeur: RUIZ, Jean-Christophe, 30290 Laudun l'Ardoise (FR); LUMIA, Guy, 30130 Pont-Saint-Esprit (FR); AUDOIN, Claire, 38330 Saint-Ismier (FR); GRANDJEAN, Agnès, 30330 Saint-Marcel-de-Careiret (FR); SERASSET, Marion, 73170 Saint-Paul-sur-Yenne (FR)
(74) Mandataire: Santarelli
(86) Numéro de dépôt international: PCT/FR2021/051474
(87) Numéro de publication internationale: WO 2022/058669

(56) Documents cités:
- JP-A- 2012 228 661
- FONSECA JUAN DIEGO ET AL: "Effects of steam on the thermal dehydrochlorination of poly(vinyl chloride) resin and flexible poly(vinyl chloride) under atmospheric pressure", POLYMER DEGRADATION AND STABILITY, vol. 117, 1 July 2015 (2015-07-01), GB, pages 8 - 15, XP055808844, ISSN: 0141-3910, DOI: 10.1016/j.polymdegradstab.2015.03.011

## Description

### DOMAINE TECHNIQUE

L'invention concerne un procédé de traitement de matériaux comprenant des composés organiques par un milieu aqueux dense sous pression à l'état subcritique ou supercritique.

Plus exactement, l'invention a trait à un procédé de traitement d'un matériau (dit matériau substrat) comprenant un composé organique susceptible de libérer des anions indésirables lors d'un traitement thermique, et/ou chimique et/ou physique, par mise en contact dudit matériau avec un milieu aqueux dense sous pression à l'état subcritique ou supercritique.

Le domaine technique de l'invention peut être défini comme celui du traitement de composés organiques potentiellement dangereux ou toxiques en vue de leur destruction, par Oxydation Hydrothermale (OHT), Oxydation par Voie Humide (OVH).

Le procédé selon l'invention s'applique notamment, mais pas seulement, au traitement des composés organiques halogénés, notamment fluorés.

### ÉTAT DE LA TECHNIQUE ANTÉRIEURE

Les préoccupations environnementales nécessitent de développer des procédés industriels qui soient respectueux de l'environnement, en particulier qui n'utilisent pas de solvants organiques toxiques et qui ne produisent pas de déchets toxiques nécessitant un traitement long et coûteux.

La production toujours en augmentation de nombreux produits manufacturés utilisés quotidiennement (que ce soit pour une utilisation à large échelle ou pour une utilisation domestique) tel que les téléphones portables, les ordinateurs, les téléviseurs, les panneaux solaires, voire les emballages et les revêtements, jusqu'aux fluides comme des huiles fluorés, frigorigènes génèrent, lorsque ces produits sont en fin de vie, des déchets qui posent de nombreux problèmes lors de leur traitement.

Ces problèmes sont encore accentués si ces déchets contiennent des composés toxiques, corrosifs ou nocifs ou susceptibles de libérer des composés toxiques, corrosifs ou nocifs, tels que les polymères halogénés.

Le traitement, notamment en vue de leur destruction ou de leur recyclage, de certains produits fabriqués pour l'industrie ou pour la consommation domestique peut s'avérer complexe.

C'est notamment le cas des composés organiques contenant des anions corrosifs, toxiques, ou nocifs pour l'homme et l'environnement, ou plus exactement des composés organiques susceptibles de libérer des anions toxiques, nocifs, ou corrosifs lorsqu'ils sont soumis à un traitement thermique, physique ou chimique.

Les huiles halogénées, notamment les huiles fluorées, utilisées dans l'industrie mécanique, les résines retardatrices de flamme bromées utilisées dans les cartes d'ordinateurs, de nombreux types de solvants halogénés et phosphorés, les polymères halogénés présents dans les modules photovoltaïques et les dispositifs électriques et électroniques, les organosulfates etc. sont autant d'exemples de composés organiques contenant des anions toxiques tels que des anions halogénures, ou plutôt de composés susceptibles de libérer des anions toxiques lorsqu'ils sont soumis à un traitement thermique, physique ou chimique.

Du fait de la libération d'anions toxiques lors du traitement de ces composés organiques, présents généralement dans des déchets, celui-ci s'avère particulièrement difficile.

Concernant le cas particulier du Fluor, de nombreux procédés industriels génèrent une importante quantité d'effluents gazeux ou liquides contaminés par le Fluor, comme la fabrication du fer et de l'aluminium, la fabrication des engrais chimiques et des semiconducteurs. En fait, ces effluents contaminés par le Fluor sous forme d''anions fluorure représentent un risque pour la santé humaine, du fait de la production d'HF, et une vraie problématique environnementale car ils peuvent être très corrosifs et très toxiques pour les écosystèmes en général et pour l'homme en particulier. L'acide fluorhydrique constitue également un problème pour l'intégrité des composants pour divers procédés de traitements en phase liquide, en phase gazeuse. La plupart des alliages métalliques, le verre n'y résiste pas.

Des procédés tels que les procédés hydro métallurgiques sont en général peu efficaces et présentent, en outre, des inconvénients majeurs d'un point de vue environnemental.

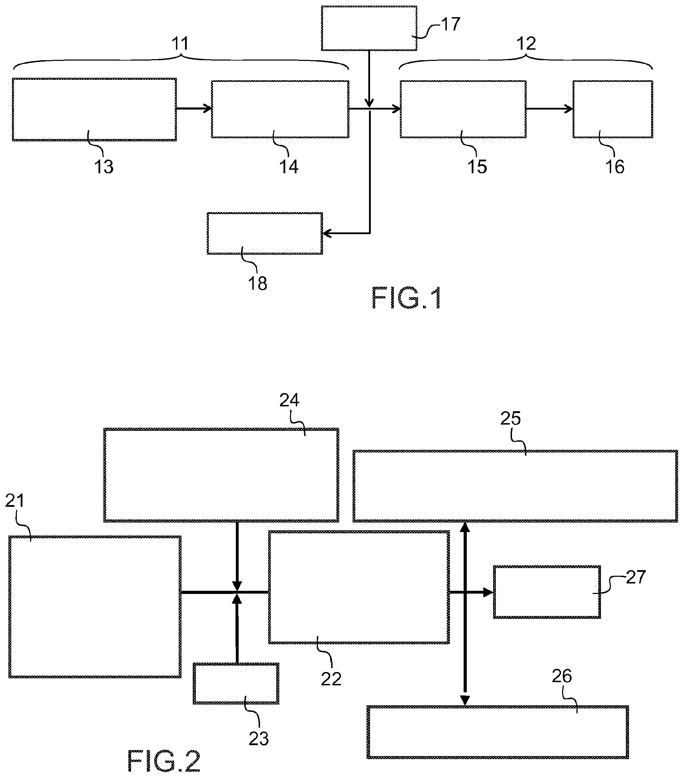

La Figure 1 est un schéma qui décrit des procédés actuels (comme les procédés hydro métallurgiques) de traitement de déchets organiques qui produisent des anions dangereux, toxiques, nocifs ou corrosifs. Ces déchets organiques peuvent être solides ou liquides et peuvent donc générer des anions dangereux, toxiques, tels que des anions fluorure, chlorure, bromure, ou phosphate.

Ces procédés comprennent généralement au minimum deux étapes, comme cela est indiqué sur la Figure 1. Dans une première étape, les déchets organiques sont traités thermiquement ou chimiquement afin de détruire la matière organique. Dans une seconde étape, un post-traitement des effluents gazeux issus de la première étape, est nécessaire pour éliminer les anions libérés durant la première étape. A la fin du procédé, on obtient des effluents finaux débarrassés des anions. Les anions peuvent être séparés des effluents de la première étape notamment par un traitement sur charbon actif, par adsorption, par précipitation ou par traitement avec une membrane.

Entre la première étape et la seconde étape, un matériau capable d'immobiliser les anions toxiques dans sa structure peut être ajouté pour permettre la récupération des espèces valorisables purifiées contenues dans les déchets.

Plus précisément, les procédés décrits sur la Figure 1, comprennent généralement deux opérations, à savoir une opération unitaire I (11) et une opération unitaire II (12). Lors de l'opération unitaire I (11), on fournit des déchets organiques générateurs des anions dangereux (13). Ces anions dangereux peuvent être des anions F⁻, Cl⁻, Br⁻, PO₄³⁻ ... Ces déchets organiques peuvent être solides ou liquides. On procède ensuite à un traitement (14) de la phase organique. Ce traitement (14) peut être un traitement thermique ou chimique. Dans l'opération unitaire II (12), on réalise un traitement (15) des anions issus du traitement (14) de la phase organique réalisé lors de l'opération unitaire I (11). Ce traitement (15) des anions peut être un traitement sur du charbon actif, un traitement par adsorption, un traitement par précipitation, ou un traitement avec des membranes. Suite à ce traitement (15) des anions, on obtient des effluents (16) ne contenant plus d'anions. Entre l'opération unitaire I (11) et l'opération unitaire II (12), plus exactement entre le traitement de la phase organique (14) et le traitement des anions (15), un matériau spécifique (17) peut être ajouté afin de récupérer, lors d'une étape de récupération (18) des espèces valorisables telles que des métaux.

Les composés organiques contenant des anions toxiques peuvent notamment être traités par des procédés (qui font partie des procédés de traitement chimiques et/ou thermiques de la phase organique mentionnés sur la Figure 1) mettant en œuvre une Oxydation Hydrothermale (OHT), une Oxydation par Voie Humide (OVH) ou encore une oxydation par de la vapeur d'eau qui utilisent de l'eau pressurisée et à température élevée.

Par exemple, les huiles fluorées et chlorées sont des composés qui peuvent être utilisés comme lubrifiants pour les machines industrielles. Cependant, la destruction de ces composés par Oxydation Hydrothermale (OHT) ou par Oxydation par Voie Humide (OVH), produit des anions chlorure (Cl⁻) et fluorure (F⁻) qui génèrent ensuite les acides correspondants (à savoir, l'acide chlorhydrique (HCl) et l'acide fluorhydrique (HF)). Ces acides sont produits à des concentrations qui sont fonction de la concentration des composés traités initialement introduits dans le milieu d'eau subcritique (OVH), d'eau supercritique (OHT), ou de vapeur d'eau.

Les organosulfates, sont notamment utilisés comme détergents dans l'industrie. La destruction de ces composés dans les mêmes conditions de température et de pression conduit à la production d'anions sulfate (SO₄²⁻), puis, à la formation d'acide sulfurique (H₂SO₄).

Les composés organiques avec un groupe nitrate (NO₃⁻) sont notamment utilisés dans l'industrie pharmaceutique. La destruction de ces composés dans les mêmes conditions de température et de pression conduit à la production d'anions nitrate puis à la formation d'acide nitrique (HNO₃).

Dans l'industrie nucléaire, le tributylphosphate (TBP) est utilisé dans le procédé de retraitement du combustible nucléaire afin d'en extraire l'uranium et le plutonium. Le traitement du TBP contaminé dans les mêmes conditions de température et de pression produit des anions phosphates (PO₄³⁻) qui forment ensuite de l'acide phosphorique (H₃PO₄).

La formation de tous ces composés anioniques et de tous ces acides représente un risque pour les équipements exposés à des conditions de pression et de température contraignantes, du fait notamment qu'ils produisent des phénomènes de corrosion sous contrainte et sous dépôt (c'est-à-dire une corrosion induite par le dépôt de sels sur les parois internes). Il se pose, en outre, des problèmes lors du traitement de ces composés anioniques et de ces acides à l'issue de l'action de l'eau subcritique ou supercritique ou de la vapeur d'eau. Il se pose en particulier des problèmes liés au fait que la forte toxicité de ces composés rend difficile, voire dangereuse, leur manipulation par l'homme et constitue une menace pour les écosystèmes aquatique et terrestre.

En outre, les déchets qualifiés de déchets organiques, qui proviennent notamment de produits manufacturés en fin de vie, sont le plus souvent en fait des « multi composés » constitués d'une grande diversité de matières organiques solides ou liquides associées avec des métaux et/ou des minéraux.

Cette combinaison de matières plus ou moins complexe rend les opérations de tri puis de traitement et/ou de recyclage difficiles.

Par exemple, une carte électronique d'un ordinateur est une plaque de résine époxy doublée d'une fine couche de cuivre recouverte de vernis, et sur laquelle sont intégrés des dispositifs électroniques et connectiques. Classiquement, une carte électronique est constituée d'environ 40% de métaux, de 30% de fibre de verre, et de céramique et de 30% de matière organique. La présence de résine époxy toxique et de retardateurs de flamme bromés ne permet pas d'envisager un cycle de recyclage simple et vertueux. L'incinération de ces composants électroniques est également inappropriée car elle produit des émissions toxiques de vapeurs de métaux lourds et de dioxine bromés. Le traitement chimique peut être envisagé mais peut générer des effluents toxiques contenant de l'acide bromhydrique (HBr). Dans ce type de traitement, l'anion bromure (Br⁻) peut être relargué en grande quantité et un post traitement doit être envisagé.

Les modules de panneaux photovoltaïques (PV) sont également difficiles à traiter en raison de la présence d'un polymère fluoré, tel que le poly (fluorure de vinyle) (« *PVF » « Poly Vinyl Fluoride* ») qui est constitutif du film, ou couche de protection (couche arrière) appelé *« Backsheet ».* Ce « Backsheet » est constitué généralement de plusieurs couches de polymères. Il s'agit le plus souvent de 2 couches de polymère fluoré (PVF, PVDF ou autre) entourant une couche de PET. Il existe aussi des « Backsheets » sans polymère fluoré, composés par exemple de 2 couches de PET.

La destruction totale ou partielle par une Oxydation Hydrothermale (OHT), une Oxydation par Voie Humide (OVH) ou encore une oxydation par la vapeur d'eau, de ce polymère produit dans ces conditions de température et de pression de l'acide fluorhydrique (HF), composé très agressif voire incompatible avec des équipements en acier inox ou avec la plupart des alliages.

Au regard de ce qui précède, il apparaît que les procédés d'oxydation Hydrothermale (OHT), d'Oxydation par Voie Humide (OVH) ou encore d'oxydation par la vapeur d'eau, pour le traitement de matériaux contenant des composés organiques présentent de nombreux avantages notamment en termes de respect de l'environnement car ils ne mettent en œuvre que de l'eau et génèrent au stade ultime que du gaz carbonique et de l'eau.

Par exemple, l'intérêt principal des procédés OHT ou OVH ou à la vapeur d'eau pour le recyclage de composants électroniques est la capacité de ces procédés à traiter des matériaux organométalliques liquides ou solides avec un taux élevé de destruction de la matière organique et de récupération de métaux d'intérêt.

De plus, les émissions de NOₓ et SOₓ produites par ces procédés sont très limitées pour ce type de procédé.

Mais, comme on l'a précisé plus haut, lorsque ces procédés sont utilisés pour traiter dans une première étape des composés qui libèrent des anions indésirables, à savoir, dangereux, toxiques, nocifs, ou corrosifs dans les conditions de ces procédés, il est nécessaire d'éliminer ensuite, lors d'une seconde étape séparée, les anions libérés contenus dans les effluents de la première étape. Les procédés visant à l'élimination de ces anions sont complexes, consomment du temps et de l'énergie, et leur efficacité n'est souvent pas optimale.

La demande de brevet JP 2012-228661 A décrit un adsorbant pour décomposition hydrothermale et un procédé de traitement de déchets organiques, notamment infectieux ou contenant du chlore, dans lequel des composants acides et/ou des métaux lourds générés lors du traitement sont adsorbés par un matériau approprié, le traitement étant réalisé dans des conditions hydrothermales modérées.

Il existe donc, au regard de ce qui précède, un besoin pour un procédé de traitement d'un matériau comprenant un composé organique susceptible de libérer des anions indésirables lors d'un traitement thermique, et/ou chimique et/ou physique, qui permette en une seule étape, opération unitaire, simultanément de décomposer ce composé organique et de capter immobiliser les anions indésirables afin d'éviter la production de substances dangereuses, nocives, toxiques ou corrosives, telles que des acides, à partir de ces anions.

Il existe encore un besoin pour un tel procédé qui soit simple, fiable, qui n'utilise pas de solvants ou d'autres substances souvent toxiques, qui ne produise pas d'effluents toxiques, nocifs, dangereux, corrosifs, difficiles à traiter, et qui soit respectueux de l'environnement.

Le but de la présente invention est de fournir un tel procédé de traitement, qui réponde entre autres à ces besoins et à ces exigences.

Le but de la présente invention est notamment de fournir un tel procédé de traitement qui ne présente pas les inconvénients, défauts, et désavantages des procédés de traitement de l'art antérieur, notamment des procédés d'oxydation Hydrothermale (OHT), d'Oxydation par Voie Humide (OVH) ou encore d'oxydation par la vapeur d'eau.

Le but de la présente invention est aussi de fournir un tel procédé de traitement qui surmonte les problèmes qui se posent dans les procédés de traitement de l'art antérieur, et notamment dans les procédés d'oxydation Hydrothermale (OHT), d'Oxydation par Voie Humide (OVH), ou encore d'oxydation par la vapeur d'eau.

### EXPOSÉ DE L'INVENTION

Ce but et d'autres encore, sont atteints, conformément à l'invention, par un procédé de traitement d'un matériau comprenant au moins un composé organique susceptible de libérer des anions indésirables lors d'un traitement thermique, et/ou chimique, et/ou physique, ledit procédé comprenant au moins une étape au cours de laquelle on met en contact ledit matériau avec un milieu aqueux dense sous pression à l'état subcritique ou supercritique, en présence d'un matériau réactif vis-à-vis des anions indésirables et capable d'immobiliser les anions indésirables dans sa structure, moyennant quoi le composé organique est détruit, minéralisé au moins partiellement ; simultanément, les anions indésirables sont libérés, et immédiatement captés puis immobilisés par le matériau réactif vis-à-vis des anions indésirables, et une solution aqueuse exempte d'anions indésirables est produite.

Le traitement thermique peut être notamment un traitement hydrothermal.

Le matériau réactif vis-à-vis des anions indésirables peut aussi être appelé matériau capable de réagir avec les anions indésirables. Il peut être choisi notamment parmi les verres et les échangeurs ioniques.

Le matériau réactif vis-à-vis des anions indésirables est solide.

Le matériau traité comprenant au moins un composé organique susceptible de libérer des anions indésirables lors d'un traitement thermique, et/ou chimique et/ou physique, peut aussi être appelé matériau substrat.

Par minéralisation, destruction partielle, on entend que les molécules du composé organique sont décomposées en molécules de plus petite taille et de plus faible masse moléculaire mais qui comprennent encore des liaisons carbone-carbone.

Par minéralisation totale ou ultime, on entend que les molécules du composé organique sont décomposées notamment en CO₂ en N₂ et en H₂O.

Par exemple les grandes chaînes des molécules de polymères organiques peuvent, dans le cas d'une minéralisation ou destruction partielle, être décomposées en plus petites molécules ou monomères, et dans le cas d'une minéralisation, décomposition totale, ultime être décomposées notamment en CO₂ en N₂ et en H₂O.

Le procédé selon l'invention se distingue fondamentalement des procédés de traitement d'un matériau comprenant un composé organique susceptible de libérer des anions indésirables de l'art antérieur, en ce que, lors d'une même étape, est réalisée la mise en contact du matériau traité avec un milieu aqueux dense sous pression à l'état subcritique ou supercritique et l'immobilisation des anions indésirables du fait de la présence d'un matériau réactif vis-à-vis des anions indésirables, susceptible de capter les anions indésirables.

Dans le procédé selon l'invention, en une seule et même étape unitaire, le composé organique est détruit, minéralisé au moins partiellement, et simultanément, les anions indésirables sont libérés et sont, immédiatement après leur libération depuis le composé organique, captés puis immobilisés par le matériau réactif vis-à-vis des anions indésirables. Il n'est donc pas nécessaire d'avoir recours à une autre étape ultérieure pour séparer, capter, immobiliser les anions indésirables qui ont déjà été captés.

Le procédé selon l'invention ne présente pas les inconvénients, défauts et désavantages des procédés de traitement de l'art antérieur, notamment des procédés d'oxydation Hydrothermale (OHT), d'Oxydation par Voie Humide (OVH) ou encore d'oxydation par la vapeur d'eau.

Le procédé selon l'invention surmonte les problèmes qui se posent dans les procédés de traitement de l'art antérieur, et notamment dans les procédés d'oxydation Hydrothermale (OHT), d'Oxydation par Voie Humide (OVH), ou encore d'oxydation par la vapeur d'eau.

Les anions indésirables peuvent être notamment des anions dangereux et/ou toxiques et/ou nocifs, et/ou corrosifs, et/ou des anions susceptibles de former des composés dangereux et/ou toxiques et/ou nocifs, et/ou corrosifs.

Les anions indésirables peuvent être notamment choisis parmi les anions des éléments des groupes V, VI, et VII de la classification périodique des éléments, et les anions comprenant un élément des groupes V, VI, et VII de la classification périodique des éléments.

En particulier, les anions indésirables peuvent être choisis dans le groupe constitué par les anions halogénure (groupe VII de la classification périodique des éléments) tels que les anions chlorure, iodure, bromure, et fluorure; les anions sulfate (groupe VI) ; les anions nitrate ; les anions phosphate; les anions arséniates (AsO₄⁸⁻) (groupe V) ; et les anions contenant un métal, tels que les oxo et polyoxométallates des Groupes V, VI & VII de la classification périodique des éléments.

En effet, dans le procédé selon l'invention, les composés organiques sont dégradés, voire minéralisés sans que ne soient produits d'anions indésirables, et notamment d'anions corrosifs vis-à-vis des matériaux constitutifs des équipements utilisés lors du traitement avec un milieu aqueux dense sous pression à l'état subcritique ou supercritique, par exemple lors du traitement d'oxydation hydrothermale.

Les anions indésirables libérés lors de la décomposition du composé organique, interagissent simultanément à cette décomposition, avec le matériau réactif vis-à-vis des anions indésirables déjà présents. Dès qu'ils sont produits, ces anions indésirables sont immédiatement captés, immobilisés par le matériau réactif vis-à-vis des anions indésirables et ne peuvent avoir aucune action nocive, toxique, ou corrosive. Ces anions ne peuvent pas former de composés dangereux, nocifs, toxiques ou corrosifs tels que des acides.

Le procédé selon l'invention permet, de manière surprenante, de traiter avec un milieu aqueux dense sous pression à l'état subcritique ou supercritique, notamment par oxydation Hydrothermale (OHT), par Oxydation par Voie Humide (OVH), ou encore par oxydation par la vapeur d'eau des composés organiques, tels que des déchets organiques halogénés, potentiellement toxiques et corrosifs vis-à-vis des équipements en une seule opération unitaire par confinement dans un matériau réactif vis-à-vis des anions indésirables comme par exemple une matrice vitreuse.

Le procédé selon l'invention n'utilise pas de réactifs chimiques souvent toxiques et dangereux pour l'homme et pour l'environnement.

Le procédé selon l'invention, permet en une seule et même étape, en une étape unique, non seulement de minéraliser partiellement ou totalement les composés organiques, mais également, simultanément, de neutraliser, capter, immobiliser, les anions indésirables libérés durant la décomposition des composés organiques.

Autrement dit, le procédé selon l'invention assure le traitement de composés organiques, tels que de déchets organiques halogénés en une seule opération unitaire au cours de laquelle, les composés organiques sont détruits, décomposés, et au cours de laquelle ne sont pas produits d'anions indésirables, notamment d'anions halogénures toxiques. Le procédé selon l'invention ne comprend donc pas, suite à ladite étape, d'étape ultérieure pour éliminer les anions.

Autrement dit, suite au traitement avec le milieu aqueux dense sous pression à l'état subcritique ou supercritique, le procédé selon l'invention ne comprend pas de post-traitement en vue d'éliminer les anions indésirables.

Le procédé selon l'invention produit en tant qu'effluent une solution aqueuse exempte d'anions indésirables.

Cette solution peut éventuellement contenir, dans le cas d'une décomposition partielle, des molécules de plus petite taille et de plus faible masse moléculaire que les composés organiques traités sans que cette solution soit nécessairement dangereuse, nocive, toxique ou corrosive.

Les autres effluents issus du procédé, sont, dans le cas d'une minéralisation totale notamment du CO₂, du N₂, et de l'eau qui peuvent être rejetés sans aucun risque.

Dans le procédé selon l'invention, il existe une véritable synergie entre une oxydation réalisée en milieu aqueux et un matériau réactif vis-à-vis des anions indésirables qui est un matériau permettant l'immobilisation des anions indésirables produits lors de la minéralisation des composés organiques.

Finalement, le procédé selon l'invention, assure, en une seule étape, le traitement de matériaux comprenant des composés organiques par un double effet, à savoir une hydrolyse/oxydation des composés organiques et un confinement des anions indésirables, notamment toxiques et ou corrosifs au sein d'une phase inorganique (à savoir le matériau réactif vis-à-vis des anions indésirables), sans production de composés nocifs, dangereux, toxiques ou corrosifs, tels que des acides, à partir de ces composés organiques.

Le procédé selon l'invention est respectueux de l'environnement. En effet, le procédé selon l'invention met en œuvre de l'eau sous différents états et non des solvants organiques toxiques.

Il n'y a aucune limitation sur les composés organiques qui peuvent être traités en vue d'être détruits, décomposés par le procédé selon l'invention. Le matériau traité ou matériau à traiter (aussi appelé matériau substrat) comprend au moins un composé organique.

Le matériau traité (matériau substrat) et le composé organique peuvent être solides et/ou liquides.

Le composé organique du matériau traité peut notamment être choisi parmi les composés organiques halogénés liquides ou solides tels que les composés fluorés et/ou chlorés et /ou iodés.

Comme composés organiques sous forme liquide, on peut notamment citer les lubrifiants fluorés, les fluides frigorigènes et tous les résidus liquides halogénés.

Avantageusement, le composé organique du matériau traité est choisi parmi les polymères organiques, notamment les polymères organiques halogénés, comme les polymères organiques fluorés et/ou chlorés, et les résines organiques, notamment les résines organiques halogénées.

Ces polymères et résines organiques peuvent être notamment choisis parmi les poly(fluorure de vinyle) (« *PVF »* ou *« PolyVinyl Fluoride* »)*,* les Poly(fluorure de vinylidène) (« *PVDF »* ou *« PolyVinylidene Fluoride* »)*,* les poly(chlorure de vinyle) (« *PVC «* ou *« PolyVinyl Chloride* »)*,* les polystyrènes notamment les polystyrènes expansés ou mousses de polystyrène, les résines époxy, les polyamides, les polyoléfines, les polyuréthanes, les polytéréphtalates, comme le PET, les polyesters, et les polycarbonates.

Ces polymères peuvent éventuellement contenir des agents ignifugeants, tels que des composés bromés, comme les Penta-, et Octa- BDE (BromoDiphényl-Ethers).

Ces polymères peuvent être aussi des polymères iodés comme des dextranes greffés utilisés comme agent de contraste en imagerie, ou des polymères conducteurs comme les polyfluorènes, polypyrènes, polyazulènes, polynaphtalènes, polyacétylènes, et poly(p-phénylène vinylène).

Ces polymères peuvent être dopés en plus de l'Iode et du Fluor, avec des atomes tels que du Soufre (S) ou au Bore (B) ainsi que tous leurs dérivés : formes oxydées ou réduites.

Le matériau traité (matériau substrat) peut être un matériau organique, c'est à dire constitué par un ou plusieurs composé(s) organiques notamment tel que décrit plus haut ; ou bien le matériau traité peut être un matériau composite qui comprend, outre le au moins un composé organique au moins un composé qui n'est pas organique, qui est un composé inorganique.

Ce composé inorganique (qui peut constituer le matériau réactif vis-à-vis des anions indésirables) peut être choisi notamment parmi les verres, les céramiques, et les métaux.

Ledit au moins un composé inorganique (qui peut constituer le matériau réactif vis-à-vis des anions indésirables), qui peut être choisi notamment parmi les verres, les céramiques et les métaux peut alors être récupéré à l'issue de la mise en contact.

Le matériau composite (qui peut comprendre le matériau réactif vis-à-vis des anions indésirables) peut constituer ou faire partie de déchets, rejets, effluents, liquides ou solides.

Le matériau composite (qui peut comprendre le matériau réactif vis-à-vis des anions indésirables) peut constituer ou faire partie de toutes sortes de dispositifs objets, ou pièces, notamment de dispositifs objets, ou pièces en fin de vie qui sont traités en vue de leur recyclage en totalité ou en partie.

Le matériau composite (qui peut comprendre le matériau réactif vis-à-vis des anions indésirables) peut ainsi constituer un dispositif multicouche ou faire partie d'un dispositif multicouche comportant au moins une couche organique tel qu'un panneau photovoltaïque ; un module photovoltaïque, comme un module photovoltaïque mettant en œuvre une technologie au silicium, par exemple au silicium cristallin, ou tout module photovoltaïque comportant au moins une couche organique ; un emballage alimentaire ;un emballage pharmaceutique ; un dispositif électronique tel qu'un écran d'ordinateur, un téléphone portable, un téléviseur, ou un dispositif à diodes électroluminescentes, notamment à diodes électroluminescentes organiques. Dans ces dispositifs multicouche, en particulier dans les panneaux photovoltaïques, le ou les composés organiques sont sous forme solide et il s'agit généralement de polymères et notamment de polymères halogénés (PVF ou PVDF entre autres).

Le matériau composite peut être constitué par une couche de protection inférieure aussi appelée face arrière, ou couche ou feuille arrière (*« backsheet »* en anglais) d'un module photovoltaïque (module PV).

Les couches arrières ou feuilles arrières *« backsheets »* sont généralement constituées de plusieurs couches, à savoir 2 couches, 3 couches ou plus.

Chacune de ces couches est généralement constituée par un polymère choisi par exemple parmi les polymères fluorés tels que le Poly(fluorure de vinyle) (« *PVF »* ou *« PolyVinyl Fluoride »* en anglais), et le Poly(fluorure de vinylidène) (« *PVDF* » ou *« PolyVinylidene Fluoride »* en anglais) ; et les polymères non fluorés tels que Poly(téréphtalate d'éthylène) (« *PET »* ou *« PolyEthylene Terephthalate »* en anglais) et Polyamide (« PA »).

Diverses combinaisons de couches et de polymères sont possibles pour constituer les couches arrières ou feuilles arrières.

Les combinaisons suivantes ne sont données qu'à titre d'illustration et leur liste n'est absolument pas exhaustive.

Ainsi une couche arrière ou feuille arrière, constituée de trois couches, pourra comprendre une couche de PVDF/une couche de PET/une couche de PVDF, ou une couche de PVF/ une couche de PET/une couche de PVF, ou une couche d'un autre polymère fluoré (différent du PVF et du PVDF) /une couche de PET/ une couche d'un autre polymère fluoré.

Une couche arrière ou feuille arrière, constituée de deux couches, pourra comprendre une couche d'un autre polymère fluoré (différent du PVF et du PVDF) /une couche de PET, ou bien être composée par exemple de deux couches de PET.

De façon générale, une couche dite primaire d'adhésion ou un traitement pour rendre la surface active est appliqué sur la couche "interne", c'est-à-dire celle qui sera vers l'intérieur du module après laminage, stratification.

Le matériau composite peut également constituer ou faire partie d'un objet, d'un dispositif ou d'une pièce utilisés dans l'industrie automobile, aéronautique ou spatiale. Cet objet, dispositif ou pièce étant notamment un objet, dispositif ou pièce en fin de vie qui est traité en vue de son recyclage en totalité ou en partie.

Le matériau composite peut également constituer ou faire partie d'une pâle d'éolienne, notamment d'une pâle d'éolienne en fin de vie, qui est traitée en vue de son recyclage en totalité ou en partie.

Les matériaux composites cités plus haut sont généralement des matériaux susceptibles de produire des composés halogénés toxiques ou d'autres composés toxiques, lors de traitements thermiques, chimiques ou physiques.

Le milieu aqueux peut être choisi parmi l'eau et les solutions aqueuses.

Le matériau réactif vis-à-vis des anions indésirables (matériau capable de réagir avec les anions indésirables), capable d'immobiliser les anions indésirables dans sa structure, peut être choisi parmi les matériaux contenant des éléments alcalins et/ou alcalinoterreux.

Le matériau réactif vis-à-vis des anions indésirables peut notamment être choisi parmi les matériaux vitreux à base de silice contenant des éléments alcalins et/ou alcalinoterreux tels que les matériaux vitreux silico-sodocalciques, silico-borocalciques et alumino-silicocalcique, par exemple les verres silico-sodocalciques, les verres silico-borocalciques et les verres alumino-silicocalciques.

Le matériau réactif vis-à-vis des anions indésirables, capable d'immobiliser les anions indésirables dans sa structure, notamment le matériau contenant des éléments alcalins et/ou alcalinoterreux, peut être choisi parmi les matériaux naturels, notamment d'origine animale, végétale ou minérale, tels que les matériaux constituant la coquille ou la carapace d'animaux comme les mollusques et les crustacés, ou tels que les matériaux d'origine végétale à forte teneur en silice et silicocalciques ; les matériaux artificiels ; et les matériaux synthétiques.

Le matériau réactif vis-à-vis des anions indésirables capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux utilisé dans le procédé selon l'invention présente l'avantage d'être un matériau stable, disponible, et d'un faible coût.

Le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux utilisé dans le procédé selon l'invention, tel qu'un verre silico-sodocalcique ou silico-borocalcique, ou alumino-silicocalcique, peut ne pas déjà être présent dans le matériau traité, et il est alors ajouté (volontairement) au milieu aqueux dense sous pression à l'état subcritique ou supercritique et/ou au matériau à traiter (traité), généralement dans le réacteur où a lieu le procédé.

Le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux peut être ajouté en contrôlant sa forme, et/ou sa surface spécifique, et/ou sa composition et/ou sa proportion vis-à-vis des quantités de composés organiques à traiter, et selon les conditions de pression et de température appliquées.

Dans le cas où le matériau réactif vis-à-vis des anions indésirables, notamment le matériau contenant des éléments alcalins et/ou alcalinoterreux utilisé dans le procédé selon l'invention, par exemple le matériau vitreux à base de silice contenant des éléments alcalins et/ou alcalinoterreux tel qu'un verre silico-sodocalcique ou silico-borocalcique, ou alumino-silico calcique, n'est pas déjà présent dans le matériau traité, ce matériau peut être par exemple un verre fabriqué à partir de silice (SiO₂) mélangée à des fondants et à des additifs selon différentes méthodes de fabrication du verre.

Le matériau réactif vis-à-vis des anions indésirables, notamment le matériau contenant des éléments alcalins et/ou alcalinoterreux, par exemple le matériau vitreux à base de silice contenant des éléments alcalins et/ou alcalinoterreux utilisé dans le procédé selon l'invention tel qu'un verre silico-sodocalcique, ou silico-borocalcique ou alumino-silico calcique peut être issu du recyclage du verre, par exemple du recyclage de bouteilles usagées ou de déchets vitreux provenant d'isolants utilisés dans les bâtiments.

Le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silicocalcique peut être déjà présent par conception dans le matériau traité, avant que le procédé selon l'invention ne soit mis en œuvre.

C'est notamment le cas où le matériau traité (matériau substrat) est un matériau composite, tel qu'un panneau solaire photovoltaïque, un écran de dispositif électronique, ou tout autre matériau comprenant plusieurs composés (matériau multicomposé) par exemple des polymères, du verre et des métaux.

Le verre « usagé » déjà présent dans le matériau traité préalablement au procédé selon l'invention peut être un verre fabriqué par un procédé classique ou un verre recyclé.

Le matériau réactif vis-à-vis des anions indésirables capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silico calcique peut se présenter sous une grande variété de formes et de tailles, notamment lorsqu'il n'est pas déjà présent dans le matériau traité et qu'il est ajouté.

Avantageusement, le matériau réactif vis-à-vis des anions indésirables capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silico calcique se présente sous la forme de particules (discrètes) telles que des grains, des granulés, ou des billes voire de particules avec des formes aléatoires, ce qui augmente sa surface spécifique disponible pour l'adsorption des anions indésirables.

De préférence, ces particules ont une taille, définie par leur plus grande dimension, telle qu'un diamètre, dans le cas des billes, de 10 nm à 5 cm, de préférence encore de 100 nm à 1 cm, mieux de 0,1 mm à 2 mm, mieux encore de 0,5 mm à 2 mm. Des particules avec une telle taille, que l'on peut qualifier de « petites » particules ont une surface spécifique disponible encore augmentée pour la réaction avec les anions indésirables, pour l'immobilisation des anions indésirables.

Bien évidemment, le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silico calcique, qu'il soit déjà présent dans le matériau traité, avant que le procédé selon l'invention ne soit mis en œuvre, ou qu'il ne soit pas déjà présent dans le matériau traité, peut se présenter sous une forme autre que celle de particules, par exemple sous la forme, d'une feuille, d'une couche, d'une pièce ou d'un objet, notamment d'un macro-objet d'une taille généralement supérieure à 5 mm. Par exemple, lorsque le matériau réactif vis-à-vis des anions indésirables n'est pas déjà présent dans le matériau traité, ce matériau réactif vis-à-vis des anions indésirables peut se présenter sous la forme, d'une feuille, d'une couche, d'une pièce ou d'un objet, notamment d'un macro-objet qui constitue un garnissage ou interne du réacteur dans lequel le procédé est mis en œuvre.

Avantageusement, le matériau réactif vis-à-vis des anions indésirables, capable d'immobiliser les anions indésirables dans sa structure, par exemple le matériau vitreux, est un matériau poreux ce qui, là-encore, augmente sa surface spécifique disponible pour la captation, l'immobilisation des anions indésirables.

De préférence, le matériau réactif vis-à-vis des anions indésirables, capable d'immobiliser les anions indésirables dans sa structure, par exemple le matériau vitreux, se présente sous la forme de petites particules poreuses ce qui permet d'avoir une surface spécifique disponible maximale pour l'immobilisation des anions indésirables.

Avantageusement, le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silico calcique, a une surface spécifique de 0,1 à 1000 m²/g, de préférence de 1 à 200 m²/g, de préférence encore de 10 à 200 m²/g.

L'efficacité du piégeage, de la captation, de l'immobilisation des anions indésirables, notamment des anions fluorure est considérablement accrue lorsque le matériau réactif vis-à-vis des anions indésirables, capable d'immobiliser les anions indésirables dans sa structure, notamment le matériau contenant des éléments alcalins et/ou alcalinoterreux, par exemple le matériau vitreux à base de silice contenant des éléments alcalins et/ou alcalinoterreux tel qu'un verre silico-sodocalcique ou un verre silico-borocalcique ou un verre alumino-silico calcique possède une telle surface spécifique.

Avantageusement, le rapport masse de composé organique (il s'agit seulement de la masse du composé organique contenu dans le matériau traité (matériau substrat), à savoir la masse du composé organique contenu dans le matériau composite si le matériau traité est un matériau composite, ou la masse du composé organique constituant la totalité du matériau traité, si celui-ci est exclusivement organique comme par exemple les huiles fluorées) / masse de matériau réactif vis-à-vis des anions indésirables, capable d'immobiliser les anions indésirables dans sa structure, par exemple masse de verre silico-sodocalcique, est de 0,01 à 0,5, de préférence de 0,025 à 0,25, par exemple de 0,05 à 0,1.

Avantageusement, la mise en contact est réalisée à une température de 100°C à 600°C, de préférence de 100°C à 550°C, et à une pression de 0,2 MPa (2 bars) à 40 MPa (400 bars), de préférence pendant une durée de 1 à 600 minutes.

Selon un premier mode de réalisation du procédé ne faisant pas partie de la présente invention, on met en contact le matériau traité (matériau substrat) avec de l'eau sous pression sous forme de vapeur d'eau.

Généralement, la mise en contact est réalisée à une pression de 0,2 à 2 MPa (2 à 20 bars), et à une température de 100 à 150°C, de préférence pendant une durée de 30 à 600 minutes, mieux de 240 à 600 minutes.

Selon un deuxième mode de réalisation du procédé selon l'invention, on met en contact le matériau substrat avec de l'eau sous pression à l'état subcritique.

Généralement, la mise en contact est réalisée à une pression se situant dans la plage de plus de 2 MPa (20 bars), par exemple de 2,1 MPa (21 bars), jusqu'à moins de 22,1 MPa (221 bars), par exemple jusqu'à 22 MPa (220 bars), et à une température se situant dans la plage de plus de 150°C, par exemple de 151°C, jusqu'à moins de 374°C, par exemple jusqu'à 373°C, notamment à une température de 250°C, de préférence pendant une durée de 10 à 600 minutes de préférence encore de 30 à 600 minutes, mieux de 120 à 600 minutes.

Il est à noter que les températures et pression critiques de l'eau se situent à 374°C et 221 bars (22,1 MPa). On parle d'eau subcritique (terme bien connu) dans un domaine où l'eau surchauffée se trouve proche du point critique avec une densité qui diminue à pression constante inférieure à 221 bars (22,1 MPa).

Ce traitement est réalisé à une température et à une pression inférieures aux températures et pressions critiques de l'eau, à savoir, à une température T < 374°C et à une pression P < 22,1 MPa.

Dans les conditions de température et de pression mentionnées plus haut, l'eau est sous pression, se trouve à une température inférieure à sa température critique (< 374°C), et présente l'avantage d'être non seulement un bon solvant mais également un milieu réactif capable d'hydrolyser et donc de dégrader de manière plus efficace encore les composés organiques.

Selon un troisième mode de réalisation du procédé selon l'invention, on met en contact ledit matériau substrat avec de l'eau sous pression à l'état supercritique.

Généralement, la mise en contact est réalisée à une pression supérieure ou égale à 22,1 MPa, de préférence de 22,1 à 40 MPa (221 à 400 bars), et à une température supérieure ou égale à 374°C, de préférence de 374°C à 600°C, de préférence encore de 400 à 600°C, par exemple de 400°C, de préférence pendant une durée de 1 à 180 minutes, de préférence encore de 10 à 180 minutes, mieux de 20 à 120 minutes.

L'eau à l'état supercritique (Pc > 22,1 MPa et Tc > 374°C) possède des caractéristiques très particulières. En raison d'une baisse considérable de la constante diélectrique dans ce domaine (qui est de 80 dans les conditions normales de pression et de température, et qui est de moins de 5 au-dessus du point critique), l'eau dite supercritique est peu polaire, est capable de former avec des composés organiques et de l'oxygène une seule phase homogène et présente des propriétés de solvatation proches de celle d'un solvant organique.

En contrepartie, les sels minéraux présentent une solubilité très basse dans l'eau supercritique.

Les composés organiques solubilisés en toute proportion dans l'eau supercritique sont hydrolysés puis décomposés rapidement.

Ainsi, les grandes chaînes de molécules (à base de CHON) des polymères organiques issues du matériau substrat sont décomposées en petites molécules ou monomères ou encore, dans le cas d'une destruction ultime, en CO₂ et H₂O. Dans ces conditions, la présence d'un matériau réactif vis-à-vis des anions indésirables, capable d'immobiliser les anions indésirables dans sa structure, par exemple d'un matériau vitreux permet l'immobilisation, neutralisation des anions indésirables libérés due à l'interaction de ces derniers avec les éléments constitutifs du matériau réactif vis-à-vis des anions indésirables tel qu'un matériau vitreux.

Les réactions d'hydrolyse/oxydation peuvent être effectuées en présence ou non d'un agent oxydant (O₂, O₂/N₂, H₂O₂). La présence de l'agent oxydant, généralement introduit en sur-stœchiométrie, permet de raccourcir la durée de traitement et par conséquence de réduire la dépense énergétique.

Avantageusement, on peut mettre en contact le matériau traité (matériau substrat) (pouvant être partiellement ou totalement organique) avec le milieu aqueux dense sous pression à l'état subcritique ou supercritique, et en outre en présence d'un agent oxydant.

Un agent oxydant peut notamment être présent dans les premier, deuxième et troisième modes de réalisation décrits plus haut, du procédé selon l'invention.

De préférence, l'agent oxydant peut être choisi parmi l'oxygène pur, l'air et le péroxyde d'hydrogène H₂O₂.

La présence, mais non obligatoire d'un agent oxydant, de préférence en surstœchiométrie, permet de réduire de manière significative la durée de traitement, et donc la dépense énergétique et les couts opérationnels.

En présence d'un agent oxydant, la durée du traitement peut être de 1 à 60 minutes, dans tous les modes de réalisation du procédé selon l'invention, que l'eau sous pression soit à l'état subcritique ou à l'état supercritique.

La présence d'un agent oxydant assure en outre qu'une minéralisation totale du composé organique soit obtenue.

Le procédé selon l'invention et notamment l'étape de mise en contact peut être mise en œuvre dans un seul et même réacteur, où sont placés le matériau à traiter ou matériau substrat et le matériau réactif vis-à-vis des anions indésirables, capable d'immobiliser les anions indésirables dans sa structure, par exemple le matériau vitreux silico-sodocalcique, et où ils sont mis en contact avec le milieu aqueux dense sous pression à l'état subcritique ou supercritique.

Le procédé selon l'invention et notamment l'étape de mise en contact peut être mise en œuvre de manière continue, semi-continue, ou discontinue « *batch »* de préférence dans un seul et même réacteur.

Une mise en œuvre de manière discontinue « *batch* », de préférence dans un seul et même réacteur, sans ou avec agitation, est préférable pour les matériaux, tels que des déchets organiques, solides.

Une mise en œuvre de manière semi-continue, de préférence dans un seul et même réacteur, sans ou avec agitation, est préférable pour les matériaux, tels que des déchets organiques, semi liquides (par exemple constitués par un mélange hétérogène avec une phase dispersante liquide et une phase dispersée solide, autrement dit avec un solide en suspension dans un liquide), ou à la fois solides et liquides.

Une mise en œuvre de manière continue, de préférence dans un seul et même réacteur, sans ou avec agitation, est préférable pour les matériaux, tels que des déchets organiques, liquides.

L'invention sera mieux comprise à la lecture de l'exposé de modes de réalisation particuliers, notamment sous la forme d'exemples, donné dans ce qui suit, à titre illustratif et non limitatif.

Cet exposé est fait en relation avec les dessins joints.

### BRÈVE DESCRIPTION DES DESSINS

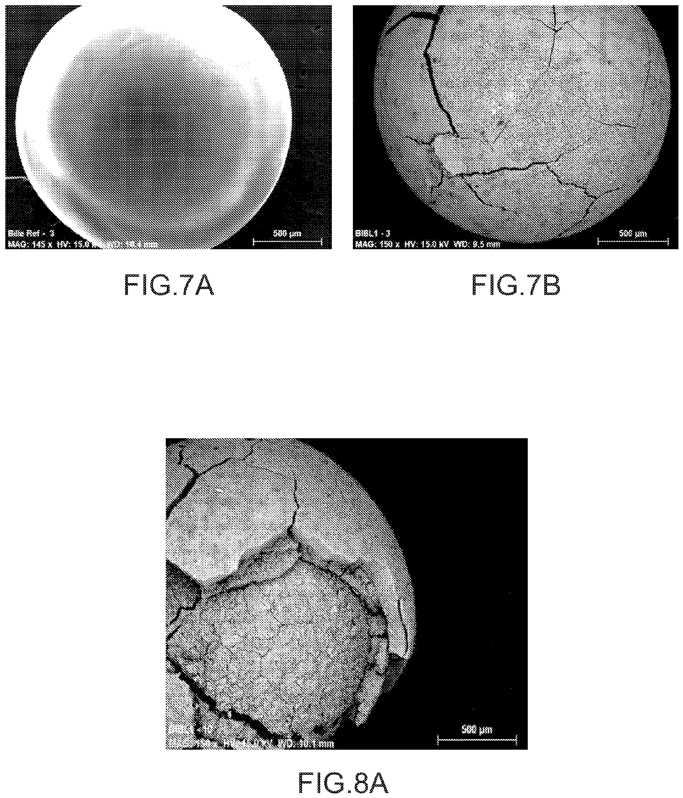

[Fig. 1] est un schéma des procédés connus de traitement des déchets organiques qui génèrent des anions dangereux.
[Fig. 2] est un schéma du procédé selon l'invention.
[Fig. 3] est un spectrogramme, réalisé en chromatographie ionique sur la phase aqueuse résiduelle obtenu après le traitement d'une couche arrière *(« backsheet »)* d'un module photovoltaïque par de l'eau supercritique en l'absence de matrice silico-sodocalcique (Exemple 2).
   En ordonnée est portée la conductivité (en µS/cm), et en abscisses est porté le temps (en minutes). On mesure la conductivité ionique du milieu qui est ensuite comparée à une courbe d'étalonnage pour avoir la concentration.
[Fig. 4] est un graphique qui montre la capacité de piégeage des ions fluorure (F⁻) par des billes de verre de 2 mm de diamètre en fonction du rapport pondéral entre la masse du *« backsheet* » traité(m_{BA}) et la masse des billes de verre (m_{BI}) *: m_{BA}*/*m_{BI}* (Exemple 4)
   En ordonnée, est portée la capacité de piégeage du fluor (en mg/g), et en abscisse est porté le rapport de masses m_{BA}/m_{BI}.
   Les points (∘) sont les valeurs expérimentales de la capacité obtenues, et la courbe en trait plein est la courbe tracée en régression logarithmique.
[Fig. 5] est un graphique qui montre le taux de piégeage des ions fluorure après traitement d'un *« backsheet* » d'un module photovoltaïque par le procédé selon l'invention (Exemple 4).
   En ordonnée, est porté le taux de piégeage des ions fluorure (en %), et en abscisse est porté le rapport de masses m_{BA}/_{BI}.
   Les points (o) sont les valeurs expérimentales du taux de piégeage obtenues, et la courbe en traits pointillés est la courbe tracée en régression logarithmique.
[Fig. 6A] est une photographie prise au microscope optique de billes de verre avant le traitement d'une couche arrière *(« backsheet »)* d'un module photovoltaïque par de l'eau supercritique en présence d'un matériau réactif vis-à-vis des anions indésirables comme une matrice silico-sodocalcique (Exemples 3, 4).
[Fig. 6B] est une photographie prise au microscope optique de billes de verre après le traitement d'une couche arrière *(« backsheet »)* d'un module photovoltaïque par de l'eau supercritique en présence d'un matériau réactif vis-à-vis des anions indésirables , à savoir une matrice silico-sodocalcique (Exemples 3, 4).
[Fig. 7A] est une photographie prise au Microscope électronique à Balayage (MEB) de billes de verre avant le traitement d'une couche arrière *(« backsheet »)* d'un module photovoltaïque par de l'eau supercritique en présence d'un matériau réactif vis-à-vis des anions indésirables, à savoir une matrice silico-sodocalcique (Exemples 3, 4).
   L'échelle portée sur la Figure 7A représente 500 µm.
[Fig. 7B] est une photographie prise au Microscope électronique à Balayage (MEB) de billes de verre après le traitement d'une couche arrière *(« backsheet »)* d'un module photovoltaïque par de l'eau supercritique en présence d'un matériau réactif vis-à-vis des anions indésirables, à savoir une matrice silico-sodocalcique (Exemples 3, 4).
   L'échelle portée sur la Figure 7B représente 500 µm.
[Fig. 8A]

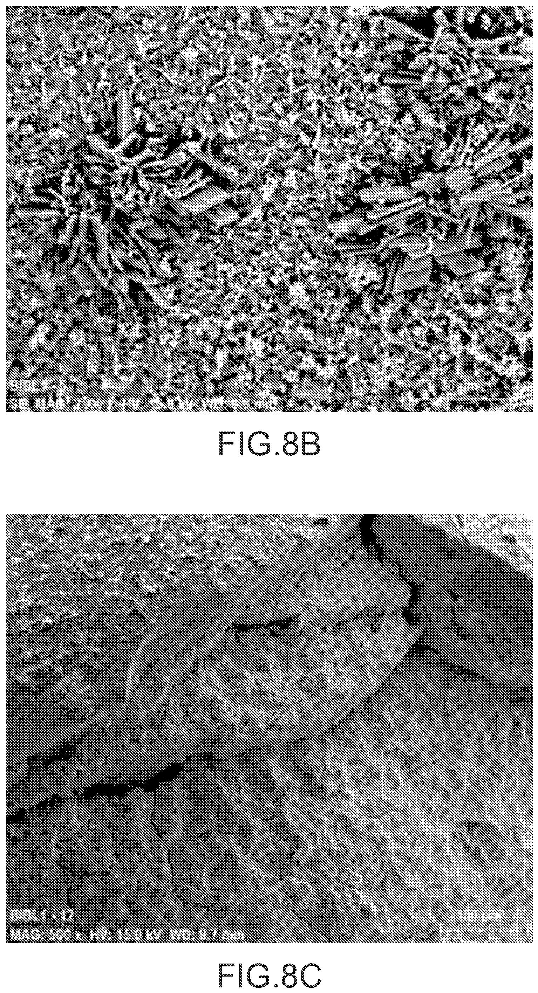

[Fig. 8B] et
[Fig. 8C] sont des photographies prises au Microscope électronique à Balayage (MEB), avec trois grossissements, de billes de verre après le traitement d'une couche arrière *(« backsheet »)* d'un module photovoltaïque par de l'eau supercritique en présence d'un matériau réactif vis-à-vis des anions indésirables, à savoir une matrice silico-sodocalcique (Exemples 3, 4).
   L'échelle portée sur la Figure 8A représente 500 µm.
   L'échelle portée sur la Figure 8B représente 30 µm.
   L'échelle portée sur la Figure 8C représente 100 µm.

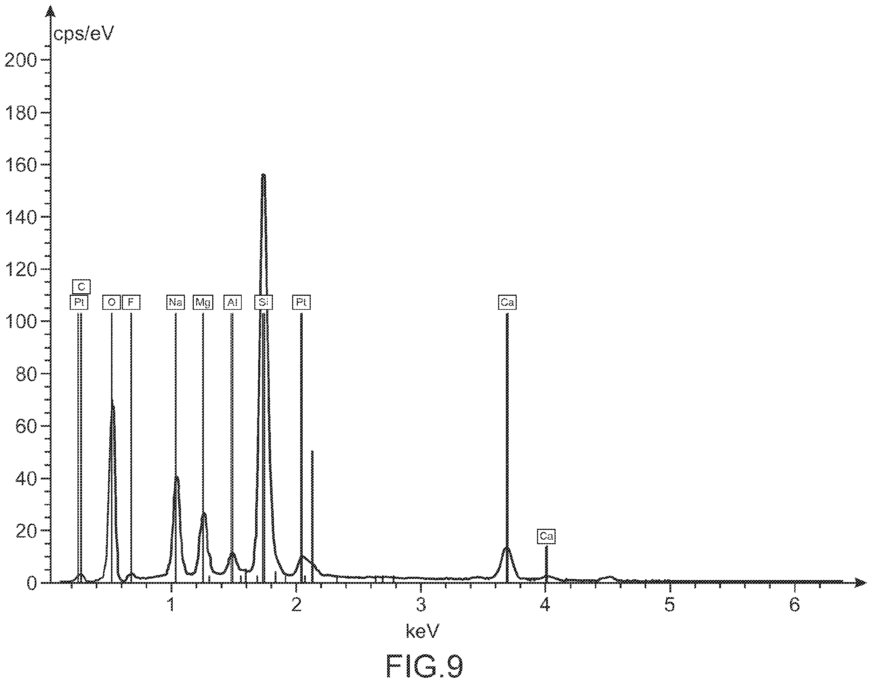

[Fig. 9] est un spectre réalisé en Spectroscopie à rayons X à dispersion d'énergie, (EDX, *« Energy Dispersive X-ray Spectroscopy* ») de billes de verre (matériau réactif vis-à-vis des anions indésirables) après traitement.
   En ordonnée sont portés les cps/eV.
   En abscisse sont portés les keV.

### EXPOSÉ DÉTAILLÉ DE MODES DE RÉALISATION PARTICULIERS

La Figure 1, déjà décrite, est un schéma d'un procédé classique tel qu'il est décrit dans la littérature. L'analyse de la bibliographie montre qu'il existe de nombreux procédés capables de traiter chimiquement ou thermiquement des déchets organiques mais pour lesquels, sans exception, le traitement de la phase organique (destruction des composés) et le traitement des anions (captés par une matrice spécifique) s'effectuent selon deux opérations unitaires distinctes.

La Figure 2 est un schéma du procédé selon l'invention pour traiter des matériaux (21) (matériaux substrats), tels que des déchets solides ou liquides comprenant des composés organiques susceptibles de libérer des anions indésirables, à savoir dangereux, toxiques, nocifs, corrosifs, ou plutôt des anions susceptibles de former des composés indésirables, à savoir dangereux, toxiques, nocifs, corrosifs, tels que des anions halogénure (fluorure, chlorure, bromure, iodure), phosphate, sulfate, nitrate.

Ces matériaux sont soumis ensuite notamment à un traitement (22) en milieu aqueux dense sous pression.

Ainsi, ces matériaux (21) peuvent être envoyés ou placés dans un réacteur aussi appelé contacteur haute pression dans lequel ils sont soumis à un traitement (22) par un milieu aqueux dense à l'état subcritique ou supercritique.

Par «envoyés », on entend généralement que les matériaux (21) sont introduits dans le réacteur pendant le procédé. Ce qui est généralement le cas pour des matériaux liquides mais pas pour des matériaux solides.

Par «placés », on entend généralement que les matériaux (21) sont disposés dans le réacteur préalablement au procédé. Ce qui est généralement le cas pour des matériaux solides.

Ce réacteur est adapté au milieu réactionnel, à savoir l'eau subcritique, ou l'eau supercritique. Le matériau constituant le réacteur sera un matériau, tel que l'Inconel, qui résiste au milieu le plus agressif mis en œuvre, à savoir l'eau supercritique.

De l'eau (23) et un matériau (24) réactif vis-à-vis des anions indésirables, capable d'immobiliser les anions indésirables dans sa structure, par exemple un matériau vitreux, tel qu'un matériau vitreux silico-sodocalcique (par exemple un verre silico-sodocalcique), sont introduits séparément ou ensemble directement dans le réacteur et/ou dans le matériau à traiter avant qu'il ne soit introduit dans le réacteur.

Le matériau réactif vis-à-vis des anions indésirables, capable d'immobiliser les anions indésirables dans sa structure, par exemple le matériau vitreux, peut-être déjà présent dans le matériau (21) à traiter, et/ou être ajouté volontairement à celui-ci ou à l'eau avant l'introduction dans le réacteur (22), ou ajouté directement dans celui-ci.

A l'issue de l'étape unique de mise en contact (22) du procédé avec le matériau traité (21) (matériau substrat) selon l'invention, réalisée dans le réacteur, contacteur, on obtient (25) un matériau réactif vis-à-vis des anions indésirables, par exemple un matériau vitreux, tel qu'un matériau silico-sodocalcique (par exemple un verre silico-sodocalcique), sur et dans lequel sont immobilisés, les anions (par exemple les anions F⁻, Cl⁻, Br⁻, I⁻) libérés du fait de la décomposition, minéralisation, des composés organiques sous l'action du milieu aqueux sous pression. Ce matériau (25) réactif vis-à-vis des anions indésirables, par exemple ce matériau vitreux, tel qu'un verre silico-sodocalcique ou silico-borocalcique, reste dans le réacteur à la fin du procédé et peut être récupéré et évacué.

Si le matériau traité (matériau substrat) est un matériau composite qui comprend, outre les composés organiques des composés inorganiques tels que des métaux, céramiques, verres, ces composés inorganiques, qui constituent des matériaux valorisables, tels que des métaux, sont récupérés dans le réacteur, puis éventuellement recyclés.

Sur la Figure 2, la récupération des matériaux valorisables, tels que des métaux, est désignée par la référence (26)

Pendant et à l'issue de l'étape unique de mise en contact du procédé selon l'invention sont également produits des effluents (27) liquides, à savoir une solution aqueuse qui ne contient pas d'anions indésirables et qui peut contenir certains produits de décomposition des composés organiques si la décomposition est seulement partielle. Ces effluents liquides sortent généralement du réacteur en continu pendant le procédé.

Durant (c'est-à-dire pendant et à la fin de) l'étape unique de mise en contact du procédé selon l'invention, sont produits des effluents (27) gazeux. Ces effluents gazeux peuvent contenir des gaz issus de la décomposition des composés organiques tels que de l'eau, de l'oxygène, de l'azote et du gaz carbonique, si la décomposition de ces composés organiques est totale.

Ces effluents gazeux peuvent éventuellement, en outre, contenir un agent oxydant tel que de l'oxygène, si on a utilisé un agent oxydant tel que de l'oxygène, en surstœchiométrie.

Ces effluents gazeux sortent généralement du réacteur en continu pendant le procédé.

L'invention va maintenant être décrite en référence aux exemples suivants donnés à titre illustratif et non limitatif.

### Exemples.

Dans les exemples qui suivent et qui illustrent le procédé selon l'invention, l'anion fluorure (F⁻) a été choisi comme anion à éliminer car il conduit à la production d'HF (Acide Fluorhydrique), qui compte parmi les acides les plus agressifs et les plus dangereux et qui pose d'importants problèmes de tenue des matériaux avec lesquels il se trouve en contact.

Dans l'exemple 1, selon l'invention, on met en œuvre le procédé de l'invention sur une solution aqueuse modèle de fluorure de sodium (NaF).

Cette solution modèle de fluorure de sodium (NaF) est utilisée comme exemple de déchet, effluent, liquide (matériau substrat) à haute concentration en fluorure (1200 ppm) pour illustrer le phénomène de piégeage des ions fluorures par un matériau réactif vis-à-vis des anions indésirables, comme ici du verre silico-sodocalcique introduit dans le milieu, conformément au procédé selon l'invention.

Dans l'exemple 2, non conforme à l'invention, on traite des échantillons d'une couche arrière « *backsheet »,* comme celle présente dans des modules photovoltaïques (matériau substrat) constituée d'un assemblage multicouche constitué de polyéthylène téréphtalate (PET) en adhésion entre deux couches de polymère fluoré tel que le fluorure de polyvinyle (PVF), par de l'eau supercritique, sans verre silico-sodocalcique (matériau réactif vis-à-vis des anions indésirables).

Dans l'exemple 3, selon l'invention, on met en œuvre le procédé de l'invention sur des échantillons d'une couche arrière *« backsheet »,* comme celle présente dans des modules photovoltaïques (matériau substrat). Ces échantillons d'une couche arrière *« backsheet »,* comme celle présente dans des modules photovoltaïques, sont utilisés comme exemples de déchets organiques solides (matériau substrat).

La couche arrière traitée dans cet exemple est constituée par une couche de PET entre deux couches de PVF.

Cet exemple vise à démontrer que l'absorption des ions fluorures par une matrice de verre silico-sodocalcique (matériau réactif vis-à-vis des anions indésirables) reste effective pendant la réaction d'oxydation (hydrothermale dans cet exemple) des polymères (matériau substrat).

La chromatographie ionique est utilisée pour quantifier les fluorures dans la phase liquide résiduelle après traitement aussi bien de la solution de NaF que du « backsheet ».

La structure finale de la phase solide est caractérisée par microscopie électronique à balayage (MEB) dans le cas du traitement du « backsheet ».

### Exemple 1.

Dans cet exemple, on réalise le traitement d'un effluent aqueux contenant des anions fluorure.

Comme on l'a déjà précisé plus haut, une solution aqueuse de NaF contenant une concentration en fluorure de 1200 ppm (concentration initiale [F⁻]ᵢ en ppm) est utilisée comme effluent modèle à traiter ou matériau substrat.

L'effluent aqueux est traité dans un réacteur à haute pression en opérant en mode *« batch* » sans agitation.

Une température de consigne de 400°C est appliquée pendant un palier de deux heures : 400°C à 28,0 MPa.

Dans ces conditions de température et de pression, l'eau se trouve à l'état supercritique.

Le traitement par l'eau supercritique a lieu, conformément au procédé selon l'invention, en présence d'un matériau réactif vis-à-vis des anions indésirables qui est placé dans le réacteur.

Deux types de matériau réactif vis-à-vis des anions indésirables sont utilisés, lors d'essais séparés, à savoir :
- Des billes de verre silico-sodocalcique de 2 mm de diamètre. La surface spécifique de ces billes a été mesurée, elle est inférieure à 1 m²/g, voire même nulle ;
- Des granulés poreux de verre recyclé Poraverre^{®} d'une taille moyenne de 0,5 mm, qui présentent une surface de contact plus importante que les billes de verre silico-sodocalcique de 2 mm de diamètre. En effet, la surface spécifique de ces billes a été mesurée, elle est de 2 m²/g.
- Un volume de 35 mL de l'effluent aqueux (matériau substrat) contenant du NaF (avec une concentration initiale [F⁻]ᵢ en ppm) est mis en contact avec 6,0 g de chacun des matériaux réactifs vis-à-vis des anions indésirables.

A la fin de chaque essai, la phase liquide résiduelle est analysée par chromatographie ionique pour déterminer sa concentration de fluorure (concentration finale [F⁻]_{f} en ppm).

Le Tableau 1 ci-dessous présente les résultats du traitement en fonction du matériau réactif vis-à-vis des anions indésirables utilisé.

**[Table 1]**

| Matériau réactif vis-à-vis des anions indésirables | Diamètre matériaux (mm) | [F⁻]ᵢ en ppm | [F⁻]_{f} en ppm | R en % | Q en mg.g⁻¹ |
|---|---|---|---|---|---|
| Billes | 2 | 1200 | 303 ± 20 | 75 ± 4 | 5,3 ± 0,5 |
| Poraverre^{®} | 0,5 | 1200 | 155 ± 18 | 87 ± 3 | 6,1± 0,4 |
| Tableau 1. Résultats du traitement | | | | | |

Dans le Tableau 1, R (en %) est le rendement d'élimination du fluorure dans l'effluent, et Q (en mg.g⁻¹) est la capacité de piégeage du matériau réactif vis-à-vis des anions indésirables.

L'effet de piégeage des anions fluorure par le procédé selon l'invention, en milieu aqueux supercritique et en présence d'un matériau réactif vis-à-vis des anions indésirables d'origine vitreuse est réalisé avec plus de 70% de rendement d'élimination pour les deux matériaux vitreux employés.

Le rendement d'élimination des anions fluorure dans l'effluent (R en %), et la capacité de piégeage (Q en mg.g⁻¹) du matériau réactif vis-à-vis des anions indésirables sont supérieurs pour le Poraverre^{®}.

Ceci démontre qu'il existe une relation entre la surface développée du matériau réactif vis-à-vis des anions indésirables et sa capacité de piégeage des anions fluorures.

Ainsi, le Poraverre^{®} doté d'une surface spécifique plus importante (diamètre des billes 0,5mm) et d'une macroporosité (avec des tailles de pores d'une dizaine de µm), donc d'une surface de contact plus importante, permet d'augmenter le piégeage des ions fluorures libérés lors du traitement par l'eau supercritique.

Ce piégeage peut, dans les deux types de matériau réactif vis-à-vis des anions indésirables, s'effectuer par exemple par réaction puis immobilisation de fluorure de calcium dans le matériau réactif vis-à-vis des anions indésirables à base silico-sodocalcique. Du fluorure de calcium se forme en effet au sein de la matrice vitreuse, selon la réaction, Ca²⁺ + 2F⁻ → CaF₂, et ce fluorure de calcium se trouve piégé, immobilisé dans la matrice vitreuse, évitant ainsi sa redissolution dans la phase aqueuse, la libération des anions fluorure et l'éventuelle formation de HF, lors de la dépressurisation et du refroidissement du réacteur. Les essais sont effectués en *« batch »* fermé. La montée en température est réalisée en fonction de la puissance injectée (dans notre cas environ 5°C/min) jusqu'au palier désiré (ici 400°C). La pression est subie et dépend du volume d'eau introduit au préalable (ici 28 MPa, 280 bar). La dépressurisation du réacteur est rapide (moins de 5 minutes) et le refroidissement s'effectue en 1 heure pour notre réacteur (inertielle).

Les résultats obtenus dans cet exemple selon l'invention, permettent de confirmer que, lors de la réaction d'oxydation hydrothermale réalisée dans cet exemple, en l'absence de polymères organiques (matériau substrat), les anions fluorure sont piégés et immobilisés par la matrice silico-sodocalcique des deux matériaux réactifs vis-à-vis des anions indésirables mis en œuvre.

Cette immobilisation des ions F⁻ s'avère d'autant plus importante lorsque le matériau réactif vis-à-vis des anions indésirables, ici la matrice du verre, présente une surface de contact plus élevée.

### Exemple 2.

Dans cet exemple, non conforme à l'invention, on traite un *« backsheet »* (matériau substrat fluoré) par de l'eau supercritique en l'absence du matériau réactif vis-à-vis des anions indésirables, à savoir la matrice silico-sodocalcique.

Le traitement d'oxydation du backsheet (3,0 g) est réalisé dans cet exemple par de l'eau supercritique (Volume : 35 mL) à 400 °C et 28,0 MPa (280 bars) pendant deux heures dans un réacteur batch en en l'absence d'une matrice silico-sodocalcique.

### Résultats du traitement :

La phase liquide résiduelle, solution aqueuse finale présente les caractéristiques suivantes :
La fraction massique d'ions fluorures libérées par le backsheet (matériau substrat) dans la phase liquide résiduelle, solution aqueuse finale, est de 5,9 ± 0,5 % d'ions fluorures (il s'agit du % massique d'ions fluorure dans la solution aqueuse finale).
- La teneur en fluorure est de 493 ± 35 mg/L dans la phase liquide résiduelle, solution aqueuse finale.
- La masse de Fluor : M_{F*} est de 17,7 ± 1,4 mg dans la phase liquide résiduelle, solution aqueuse finale. Il s'agit de la masse de fluorure ramenée au volume d'eau de 35 ml.

Le pH de la phase liquide résiduelle, solution aqueuse finale est de 2,5. Le pH de départ est celui de l'eau déminéralisée, à savoir 6.

Précisons que par phase liquide résiduelle, on entend la phase liquide après traitement thermique, et que par pH de départ, on entend le pH de la phase liquide initiale avant traitement thermique.

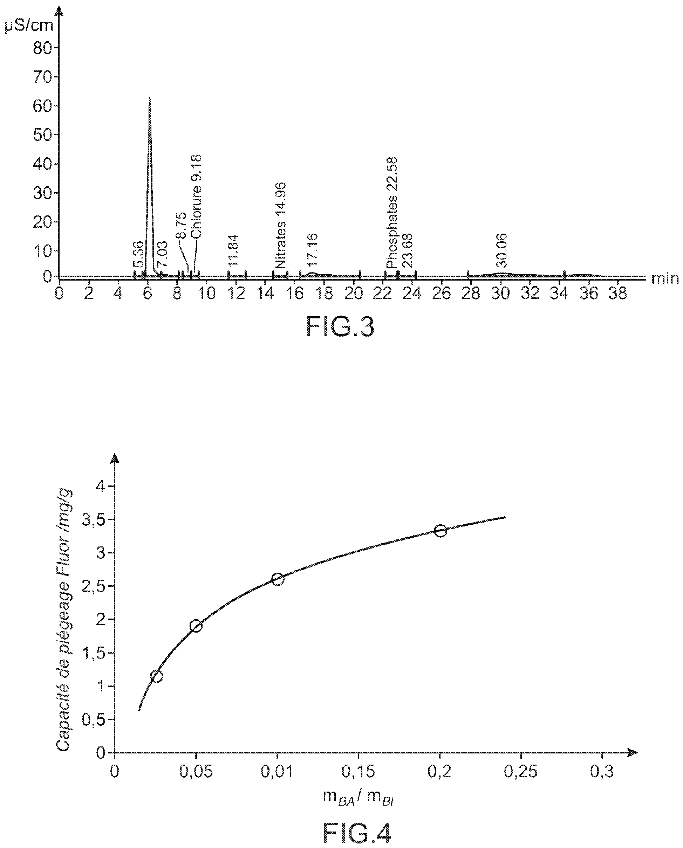

- La Figure 3 présente un spectrogramme, réalisé en chromatographie ionique sur la phase aqueuse résiduelle obtenu après le traitement du *« backsheet ».*

### Exemple 3.

Dans cet exemple, conforme à l'invention, on traite un *« backsheet »* (matériau substrat) par de l'eau supercritique dans les mêmes conditions que dans l'exemple 2, mais cette fois en présence d'un matériau réactif vis-à-vis des anions indésirables, à savoir une matrice silico-sodocalcique.

Cette matrice silico-sodocalcique est constituée par les billes de verre déjà décrites plus haut, d'un diamètre de 2 mm.

On utilise 3 g de billes de verre, ce qui donne un rapport pondéral entre la masse du backsheet (m_{BA}) (matériau substrat) et la masse des billes de verre (m_{BI}) (matériau réactif vis-à-vis des anions indésirables) : *m_{BA}*/*m_{BI} =* 0,10.

On obtient à l'issue de l'essai, une phase liquide résiduelle, solution aqueuse finale avec une concentration en fluorure de l'ordre de 318 ± 26 mg/L. Le pH est de 7,2.

### Exemple 4.

Dans cet exemple, conforme à l'invention, on traite un *« backsheet »* (matériau substrat), par de l'eau supercritique dans les mêmes conditions que dans l'exemple 3 (c'est-à-dire toujours avec des billes de 2 mm de diamètre) en présence d'un matériau réactif vis-à-vis des anions indésirables, à savoir une matrice silico-sodocalcique.

On réalise une série d'essais en faisant varier le rapport pondéral entre la masse du backsheet traité (m_{BA}) (matériau substrat) et la masse des billes de verre (m_{BI}) (matériau réactif vis-à-vis des anions indésirables) : *m_{BA}*/*m_{BI}* , entre 0,025 et 0,25.

Le graphique de la Figure 4 montre qu'il existe une relation entre la quantité de billes de verre utilisée et la capacité de piégeage du fluor (plus précisément des ions fluorures F⁻).

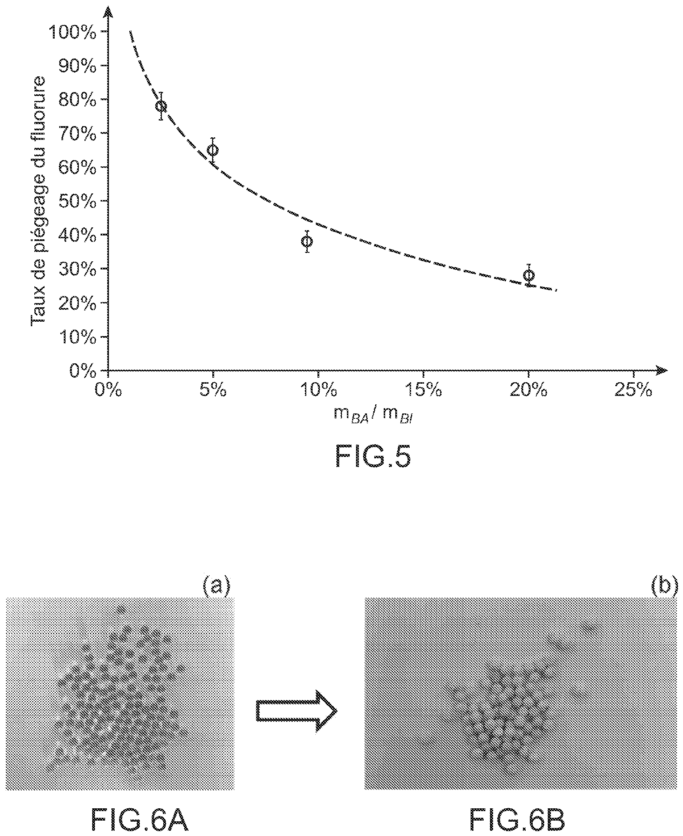

Lorsque l'on exprime ces résultats en taux de piégeage des ions fluorures ou rendement d'élimination des ions fluorure (R%) en fonction du rapport de masse utilisé (M_{BA}/m_{BI}), comme cela est montré sur la Figure 5, on constate que 80% des ions fluorure présents sont captés pour un rapport massique entre la charge silico-sodocalcique (matériau réactif vis-à-vis des anions indésirables) et le backsheet (matériau substrat) de 2,5%.

Lors des essais décrits dans les exemples 3 et 4 réalisés en milieu aqueux supercritique en présence d'un verre silico-sodocalcique, il est également observé une véritable réaction de neutralisation acido-basique avec une augmentation du pH de la phase liquide résiduelle, solution aqueuse finale (pH final voisin de 7), ce qui confirme que la consommation des ions fluorures est préférentiellement induite par le matériau réactif vis-à-vis des anions indésirables - ici la matrice de verre - aux dépens de la formation d'HF.

Autrement dit, le pH initial, avant le traitement supercritique, est celui de l'eau déminéralisée, soit environ 6. Le pH final après le traitement supercritique est neutre (pH = 7) ce qui indique l'absence d'HF dans la solution, et démontre donc que les ions fluorure ont été captés et immobilisés par le matériau réactif vis-à-vis des anions indésirables, ici dans la matrice vitreuse.

Des analyses au Microscope électronique à balayage MEB (Figures 6A, 6B, 7A, 7B, 8A, 8B, et 8C) ont été réalisées sur les matrices silico-sodocalcique avant et après traitement dans les conditions de l'exemple 3.

Le matériau réactif vis-à-vis des anions indésirables, ici une matrice silico-sodocalcique, est constitué par les billes de verre déjà décrites plus haut, d'un diamètre de 2 mm.

Le rapport pondéral entre la masse du backsheet traité (m_{BA}) (matériau substrat) et la masse des billes de verre (m_{BI}) (matériau réactif vis-à-vis des anions indésirables) : *m_{BA}*/*m_{BI} ,* se situe entre 0,025 et 0,25.

Les billes de verre dans leur forme initiale ont un aspect translucide (Fig. 6A).

Après traitement, les billes présentent un aspect laiteux (Fig. 6B) qui montre la présence d'une phase cristalline dans la matrice vitreuse, attribuée à des cristaux à base de fluorure, vraisemblablement CaF₂ (voir la réaction décrite plus haut).

L'analyse MEB confirme la modification des billes de verre traitées.

La structure globale du verre est altérée par le traitement hydrothermal, et montre des craquelures (Figures 7A, 7B, 8A, 8B, et 8C).

La caractérisation plus fine (Figures 8A, 8B, et 8C) montre la modification interne des billes avec des fissurations importantes, de nature à créer de la porosité (création d'interstices qui augmente ainsi la surface spécifique), ainsi que des dépôts de fluorures (vraisemblablement CaF₂). Les fluorures sont caractérisés par l'existence de leurs cristaux à la surface.

Une caractérisation complémentaire par EDX (Figure 9) des billes de verre (billes de verre déjà décrites plus haut, d'un diamètre de 2mm), après traitement dans les conditions de l'exemple 3, permet de constater l'existence d'un pic caractéristique du fluor proche d'autres éléments comme l'oxygène, le sodium, et le calcium.

Cette présence du fluor mesuré à la surface des billes de verre (qui est démontrée par la présence de points lumineux verts sur une photographie des billes après traitement) permet de confirmer que le Fluor libéré lors de l'oxydation hydrothermale a réagi avec la structure vitreuse pour former des cristaux de fluorure (vraisemblablement de CaF₂) stables au sein de la matrice vitreuse.

### Exemple 5.

Dans cet exemple, conforme à l'invention, on traite un *« backsheet »* (matériau substrat) par de l'eau supercritique dans les mêmes conditions que dans l'exemple 3, en présence d'une matrice silico-sodocalcique (matériau réactif vis-à-vis des anions indésirables) constituée par des granulés de verre Poraverre^{®}, avec une surface spécifique plus élevée que les billes de verre utilisées dans l'exemple 3.

On utilise 3 g de granulés de verre, ce qui donne un rapport pondéral entre la masse du backsheet (m_{BA}) et la masse des billes de verre (m_{BI}) *: m_{BA}*/*m_{BI} =* 0,10.

Dans cet exemple, l'utilisation d'une matrice silico-sodocalcique Poraverre^{®}, avec une surface spécifique plus élevée que les billes de verre précédemment utilisée, permet d'améliorer le rendement de piégeage ou taux d'élimination des fluorures jusqu'à 84% pour un rapport *m_{BA}*/*m*_{*B*I} plus faible (*m_{BA}*/*m*_{*B*I} = 0,1) et pour les mêmes conditions opératoires.

Cet exemple démontre clairement que l'efficacité du piégeage des ions fluorures lors du traitement par oxydation hydrothermale de matériau fluorés est fonction de la nature et de la surface spécifique du matériau réactif vis-à-vis des anions indésirables utilisé pour ce piégeage.

Cet exemple démontre aussi que l'efficacité du piégeage peut être considérablement augmentée en utilisant un matériau poreux possédant une surface spécifique comprise entre 0,1 et 1000 m²/g.

## Revendications

1. Procédé de traitement d'un matériau (21) comprenant au moins un composé organique susceptible de libérer des anions indésirables lors d'un traitement thermique, et/ou chimique et/ou physique (22),
**caractérisé en ce que** ledit procédé comprend au moins une étape au cours de laquelle on met en contact ledit matériau (21) avec un milieu aqueux dense sous pression à l'état subcritique ou supercritique (23), en présence d'un matériau (24) solide, réactif vis-à-vis des anions indésirables et capable d'immobiliser les anions indésirables dans sa structure, moyennant quoi le composé organique est détruit, minéralisé au moins partiellement ; simultanément, les anions indésirables sont libérés, et immédiatement captés puis immobilisés par le matériau (25) solide, réactif vis-à-vis des anions indésirables, et une solution aqueuse exempte d'anions indésirables est produite.

2. Procédé selon la revendication 1, dans lequel les anions indésirables sont des anions dangereux et/ou toxiques et/ou nocifs, et/ou corrosifs, et/ou des anions susceptibles de former des composés dangereux et/ou toxiques et/ou nocifs, et/ou corrosifs, lesdits anions indésirables étant, de préférence, choisis parmi les anions des éléments des groupes V, VI, et VII de la classification périodique des éléments et les anions comprenant un élément des groupes V, VI, et VII de la classification périodique des éléments ; en particulier, les anions indésirables sont choisis dans le groupe constitué par les anions halogénure (groupe VII de la classification périodique des éléments) tels que les anions chlorure, iodure, bromure, et fluorure; les anions sulfate (groupe VI) ; les anions nitrate ; les anions phosphate; les anions arséniates (AsO₄⁸⁻) (groupe V) ; et les anions contenant un métal tels que les oxo et polyoxométallates des Groupes V, VI & VII de la classification périodique des éléments.

3. Procédé selon la revendication 1 ou 2, dans lequel le composé organique du matériau traité est choisi parmi les polymères organiques, notamment les polymères organiques halogénés, comme les polymères organiques fluorés et/ou chlorés, et les résines organiques, notamment les résines organiques halogénées.

4. Procédé selon l'une quelconque des revendications précédentes, dans lequel le matériau traité est constitué par un ou plusieurs composé(s) organique(s) ; ou bien le matériau traité est un matériau composite qui comprend, outre le au moins un composé organique, au moins un composé inorganique, choisi notamment parmi les verres, les céramiques et les métaux, et ledit au moins un composé inorganique est récupéré à l'issue de la mise en contact.

5. Procédé selon la revendication 4, dans lequel le matériau composite constitue un dispositif multicouche, ou fait partie d'un dispositif multicouche comportant au moins une couche organique, tel qu'un panneau photovoltaïque ; un module photovoltaïque, comme un module photovoltaïque mettant en œuvre une technologie au silicium, par exemple au silicium cristallin, ou tout module photovoltaïque comportant au moins une couche organique-; un emballage alimentaire ; un emballage pharmaceutique ; un dispositif électronique tel qu'un écran d'ordinateur, un téléphone portable, un téléviseur, ou un dispositif à diodes électroluminescentes, notamment à diodes électroluminescentes organiques.

6. Procédé selon la revendication 5, dans lequel le matériau composite est constitué par une couche de protection inférieure aussi appelée face arrière, ou couche ou feuille arrière *(« backsheet »)* d'un module photovoltaïque (module PV).

7. Procédé selon l'une quelconque des revendications précédentes, dans lequel le milieu aqueux est choisi parmi l'eau et les solutions aqueuses.

8. Procédé selon l'une quelconque des revendications précédentes, dans lequel le matériau solide, réactif vis-à-vis des anions indésirables est choisi
parmi les matériaux contenant des éléments alcalins et/ou alcalinoterreux ; notamment, le matériau réactif vis-à-vis des anions indésirables est choisi parmi les matériaux vitreux à base de silice contenant des éléments alcalins et/ou alcalinoterreux tels que les matériaux vitreux silico-sodocalciques, silico-borocalciques et alumino-silicocalcique, par exemple les verres silico-sodocalciques, les verres silico-borocalciques et les verres alumino-silicocalciques, et/ou
- parmi les matériaux naturels, notamment d'origine animale, végétale ou minérale, tels que les matériaux constituant la coquille ou la carapace d'animaux comme les mollusques et les crustacés, ou tels que les matériaux d'origine végétale à forte teneur en silice et silicocalciques ; les matériaux artificiels ; et les matériaux synthétiques.

9. Procédé selon l'une quelconque des revendications précédentes, dans lequel le matériau solide, réactif vis-à-vis des anions indésirables se présente sous la forme de particules telles que des grains, des granulés, ou des billes, ou des particules de formes aléatoires ; de préférence, ces particules ont une taille, définie par leur plus grande dimension, telle qu'un diamètre, dans le cas des billes, de 10 nm à 5 cm, de préférence de 100 nm à 1 cm, mieux de 0,1 mm à 2 mm, mieux encore de 0,5 mm à 2 mm, ledit matériau réactif vis-à-vis des anions indésirables ayant, de préférence, une surface spécifique de 0,1 à 1000 m²/g, de préférence de 1 à 200 m²/g. de préférence encore de 10 à 200 m²/g.

10. Procédé selon l'une quelconque des revendications précédentes, dans lequel le rapport masse de composé organique / masse de matériau solide, réactif vis-à-vis des anions indésirables est de 0,01 à 0,5 de préférence de 0,025 à 0,25, par exemple de 0,05 à 0,1.

11. Procédé selon l'une quelconque des revendications précédentes, dans lequel le matériau solide, réactif vis-à-vis des anions indésirables est déjà présent dans le matériau traité.

12. Procédé selon l'une quelconque des revendications 1 à 10, dans lequel le matériau solide, réactif vis-à-vis des anions indésirables n'est pas déjà présent dans le matériau traité, et il est ajouté au milieu aqueux dense sous pression à l'état subcritique ou supercritique, et/ou au matériau traité.

13. Procédé selon l'une quelconque des revendications 1 à 12, dans lequel on met en contact le matériau traité avec de l'eau sous pression à l'état subcritique, à une pression se situant dans la plage de plus de 2 MPa (20 bars), par exemple de 2,1 MPa (21 bars), jusqu'à moins de 22,1 MPa (221 bars), par exemple jusqu'à 22 MPa (220 bars), et à une température se situant dans la plage de plus de 150°C, par exemple de 151°C, jusqu'à moins de 374°C, par exemple jusqu'à 373°C, notamment à une température de 250°C, de préférence pendant une durée de 10 à 600 minutes, de préférence encore de 30 à 600 minutes, mieux de 120 à 600 minutes.

14. Procédé selon l'une quelconque des revendications 1 à 12, dans lequel on met en contact le matériau traité avec de l'eau sous pression à l'état supercritique, à une pression supérieure ou égale à 22,1 MPa, de préférence de 22,1 à 40 MPa, et à une température supérieure ou égale à 374°C, de préférence de 374°C à 600°C, de préférence encore de 400°C à 600°C, par exemple de 400°C, de préférence pendant une durée de 1 à 180 minutes, de préférence encore de 10 à 180 minutes, mieux de 20 à 120 minutes.

15. Procédé selon l'une quelconque des revendications précédentes, dans lequel on met en contact ledit matériau traité avec le milieu aqueux dense sous pression à l'état subcritique ou supercritique, et en outre en présence d'un agent oxydant, ledit agent oxydant étant , de préférence, choisi parmi l'oxygène pur, l'air et le peroxyde d'hydrogène.

## Patentansprüche

1. Verfahren zur Behandlung eines Materials (21), das mindestens eine organische Verbindung umfasst, die bei einer thermischen und/oder chemischen und/oder physikalischen Behandlung (22) unerwünschte Anionen freisetzen kann,
**dadurch gekennzeichnet, dass** das Verfahren mindestens einen Schritt umfasst, bei dem das Material (21) mit einem unter Druck stehenden, dichten wässrigen Medium im subkritischen oder überkritischen Zustand (23) in Gegenwart eines festen Materials (24), das gegenüber den unerwünschten Anionen reaktiv ist und in der Lage ist, die unerwünschten Anionen in seiner Struktur zu immobilisieren, in Kontakt gebracht wird, wodurch die organische Verbindung zerstört und mindestens teilweise mineralisiert wird; gleichzeitig werden die unerwünschten Anionen freigesetzt und sofort von dem festen Material (25), das gegenüber den unerwünschten Anionen reaktiv ist, aufgenommen und immobilisiert, und es wird eine wässrige Lösung frei von unerwünschten Anionen erzeugt.

2. Verfahren nach Anspruch 1, wobei die unerwünschten Anionen gefährliche und/oder toxische und/oder schädliche und/oder korrosive Anionen und/oder Anionen sind, die gefährliche und/oder toxische und/oder schädliche und/oder korrosive Verbindungen bilden können, wobei die unerwünschten Anionen vorzugsweise aus den Anionen der Elemente der Gruppen V, VI und VII des Periodensystems der Elemente und Anionen, die ein Element der Gruppen V, VI und VII des Periodensystems der Elemente umfassen, ausgewählt sind; insbesondere sind die unerwünschten Anionen aus der Gruppe ausgewählt, die aus Halogenid-Anionen (Gruppe VII des Periodensystems der Elemente) wie Chlorid-, Iodid-, Bromid- und Fluoridanionen; Sulfatanionen (Gruppe VI); Nitratanionen; Phosphatanionen; Arsenat-Anionen (AsO₄⁸⁻) (Gruppe V); und metallhaltige Anionen wie Oxo- und Polyoxometallate der Gruppen V, VI und VII des Periodensystems der Elemente besteht.

3. Verfahren nach Anspruch 1 oder 2, wobei die organische Verbindung des behandelten Materials aus organischen Polymeren, insbesondere halogenierten organischen Polymeren, wie fluorierten und/oder chlorierten organischen Polymeren, und organischen Harzen, insbesondere halogenierten organischen Harzen, ausgewählt ist.

4. Verfahren nach einem der vorhergehenden Ansprüche, wobei das behandelte Material aus einer oder mehreren organischen Verbindungen besteht; oder das behandelte Material ein Verbundmaterial ist, das neben der mindestens einen organischen Verbindung mindestens eine anorganische Verbindung umfasst, insbesondere ausgewählt aus Gläsern, Keramiken und Metallen, und die mindestens eine anorganische Verbindung nach dem Inkontaktbringen zurückgewonnen wird.

5. Verfahren nach Anspruch 4, wobei das Verbundmaterial eine mehrschichtige Vorrichtung darstellt oder Teil einer mehrschichtigen Vorrichtung ist, die mindestens eine organische Schicht umfasst, wie ein Photovoltaikpanel; ein Photovoltaikmodul, wie ein Photovoltaikmodul, das eine Siliziumtechnologie, beispielsweise mit kristallinem Silizium, verwendet, oder jedes Photovoltaikmodul, das mindestens eine organische Schicht umfasst; eine Lebensmittelverpackung; eine pharmazeutische Verpackung; eine elektronische Vorrichtung wie einen Computerbildschirm, ein Mobiltelefon, einen Fernseher oder eine Vorrichtung mit Leuchtdioden, insbesondere mit organischen Leuchtdioden.

6. Verfahren nach Anspruch 5, wobei das Verbundmaterial aus einer unteren Schutzschicht, die auch als Rückseite oder Rückseitenschicht bzw. Rückseitenfolie ("Backsheet") eines Photovoltaikmoduls (PV-Modul) bezeichnet wird, besteht.

7. Verfahren nach einem der vorhergehenden Ansprüche, wobei das wässrige Medium aus Wasser und wässrigen Lösungen ausgewählt ist.

8. Verfahren nach einem der vorhergehenden Ansprüche, wobei das gegenüber unerwünschten Anionen reaktive feste Material ausgewählt ist
aus den Materialien, die Alkali- und/oder Erdalkali-Elemente enthalten; insbesondere ist das Material, das gegenüber unerwünschten Anionen reaktiv ist, aus glasartigen Materialien auf Siliziumdioxidbasis ausgewählt, die Alkali- und/oder Erdalkali-Elemente enthalten, wie Kalk-Natron-Siliziumdioxid-, Bor-Kalk-Siliziumdioxid- und Aluminiumoxid-Kalk-Siliziumdioxid-Glasmaterialien, beispielsweise Kalk-Natron-Siliziumdioxid-Gläser, Bor-Kalk-Siliziumdioxid-Gläser und Aluminiumoxid-Kalk-Siliziumdioxid-Gläser, und/oder
- aus natürlichen Materialien, insbesondere tierischen, pflanzlichen oder mineralischen Ursprungs, wie Materialien, aus denen die Schale oder der Panzer von Tieren wie Weichtieren und Krebstieren besteht, oder wie Materialien pflanzlichen Ursprungs mit hohem Siliziumdioxid- und Calciumsilikatgehalt; künstliche Materialien; und synthetische Materialien.

9. Verfahren nach einem der vorhergehenden Ansprüche, wobei das gegenüber unerwünschten Anionen reaktive feste Material in Form von Partikeln wie Körnern, Granulaten oder Kugeln oder Partikeln mit zufälligen Formen vorliegt; wobei diese Partikel vorzugsweise eine Größe haben, die durch ihre größte Abmessung definiert ist, wie z. B. einen Durchmesser, bei Kugeln von 10 nm bis 5 cm, vorzugsweise von 100 nm bis 1 cm, besser von 0,1 mm bis 2 mm, besser noch von 0,5 mm bis 2 mm, wobei das reaktive Material gegenüber unerwünschten Anionen vorzugsweise eine spezifische Oberfläche von 0,1 bis 1000 m²/g, vorzugsweise von 1 bis 200 m²/g, noch bevorzugter von 10 bis 200 m²/g, aufweist.

10. Verfahren nach einem der vorhergehenden Ansprüche, wobei das Verhältnis der Masse der organischen Verbindung zur Masse des gegenüber den unerwünschten Anionen reaktiven festen Materials 0,01 bis 0,5, vorzugsweise 0,025 bis 0,25, beispielsweise 0,05 bis 0,1, beträgt.

11. Verfahren nach einem der vorhergehenden Ansprüche, wobei das gegenüber unerwünschten Anionen reaktive feste Material bereits im behandelten Material vorhanden ist.

12. Verfahren nach einem der Ansprüche 1 bis 10, wobei das gegenüber unerwünschten Anionen reaktive feste Material nicht bereits im behandelten Material vorhanden ist und im subkritischen oder überkritischen Zustand dem unter Druck stehenden, dichten wässrigen Medium und/oder dem behandelten Material zugegeben wird.

13. Verfahren nach einem der Ansprüche 1 bis 12, wobei das behandelte Material mit Wasser unter Druck im subkritischen Zustand bei einem Druck im Bereich von mehr als 2 MPa (20 bar), beispielsweise von 2,1 MPa (21 bar), bis zu weniger als 22,1 MPa (221 bar), beispielsweise bis zu 22 MPa (220 bar), und bei einer Temperatur im Bereich von mehr als 150 °C, beispielsweise von 151 °C, bis unter 374 °C, beispielsweise bis 373 °C, insbesondere bei einer Temperatur von 250 °C, vorzugsweise für eine Dauer von 10 bis 600 Minuten, noch bevorzugter 30 bis 600 Minuten, besser 120 bis 600 Minuten, in Kontakt gebracht wird.

14. Verfahren nach einem der Ansprüche 1 bis 12, wobei das behandelte Material mit Wasser unter Druck im überkritischen Zustand bei einem Druck größer oder gleich 22,1 MPa, vorzugsweise von 22,1 bis 40 MPa, und einer Temperatur größer oder gleich 374 °C, vorzugsweise von 374 °C bis 600 °C, noch bevorzugter von 400 °C bis 600 °C, z. B. von 400 °C, vorzugsweise für eine Dauer von 1 bis 180 Minuten, noch bevorzugter von 10 bis 180 Minuten, besser 20 bis 120 Minuten, in Kontakt gebracht wird.

15. Verfahren nach einem der vorhergehenden Ansprüche, wobei das behandelte Material mit dem unter Druck stehenden, dichten wässrigen Medium im subkritischen oder überkritischen Zustand und ferner in Gegenwart eines Oxidationsmittels in Kontakt gebracht wird, wobei das Oxidationsmittel vorzugsweise aus reinem Sauerstoff, Luft und Wasserstoffperoxid ausgewählt ist.

## Claims

1. A method for treating a material (21) comprising at least one organic compound likely to release undesirable anions during a thermal, and/or chemical and/or physical treatment (22),
**characterized in that** said method comprises at least one step during which said material (21) is brought into contact with a dense pressurised aqueous medium under subcritical or supercritical state (23), in the presence of a solid material (24) reactive to the undesirable anions and capable of immobilising the undesirable anions in its structure, whereby the organic compound is destroyed, mineralised at least partially; simultaneously, the undesirable anions are released, and immediately captured and then immobilised by the solid material (25) reactive to the undesirable anions, and an undesirable anion-free aqueous solution is produced.

2. The method according to claim 1, wherein the undesirable anions are hazardous and/or toxic and/or harmful, and/or corrosive anions, and/or anions likely to form hazardous and/or toxic and/or harmful, and/or corrosive compounds, said undesirable anions being preferably selected from among the anions of the elements of the groups V, VI, and VII of the periodic table of elements and the anions comprising an element of the groups V, VI, and VII of the periodic table of elements; in particular, the undesirable anions are selected from among the group consisting of halide anions (group VII of the periodic table of elements) such as chloride, iodide, bromide and fluoride anions; sulphate anions (group VI); nitrate anions; phosphate anions; arsenate anions (AsO₄⁸⁻) (group V); and metal-containing anions such as oxo- and polyoxometallates of the groups V, VI & VII of the periodic table of elements.

3. The method according to claim 1 or 2, wherein the organic compound of the treated material is selected from among organic polymers, in particular halogenated organic polymers, such as fluorinated and/or chlorinated organic polymers, and organic resins, in particular halogenated organic resins.

4. The method according to any one of the preceding claims, wherein the treated material consists of one or more organic compound(s); or the treated material is a composite material which comprises, besides the at least one organic compound, at least one inorganic compound, selected in particular from among glasses, ceramics and metals, and said at least one inorganic compound is recovered upon completion of contact.

5. The method according to claim 4, wherein the composite material forms a multilayer device, or forms part of a multilayer device including at least one organic layer, such as a photovoltaic panel; a photovoltaic module, such as a photovoltaic module implementing silicon, for example crystalline silicon, technology or any photovoltaic module including at least one organic layer; food packaging; pharmaceutical packaging; an electronic device such as a computer screen, a mobile phone, a tv set, or a device with light-emitting diodes, in particular with organic light-emitting diodes.

6. The method according to claim 5, wherein the composite material consists of a lower protective layer also called back face, or back layer or sheet ("*backsheet*") of a photovoltaic module (PV module).

7. The method according to any one of the preceding claims, wherein the aqueous medium is selected from water and aqueous solutions.

8. The method according to any one of the preceding claims, wherein the solid material reactive to the undesirable anions is selected
- from among materials containing alkaline and/or alkaline-earth elements; in particular, the material reactive to the undesirable anions is selected from among silica-based vitreous materials containing alkaline and/or alkaline-earth elements such as soda-lime-silica, boro-lime-silica and silica-lime-alumina vitreous materials, for example soda-lime-silica glasses, boro-lime-silica glasses and silica-lime-alumina glasses and/or
- from among natural materials, in particular of animal, plant or mineral origin, such as the materials forming the shell or the carapace of animals such as molluscs and crustaceans, or such as materials of plant origin with a high silica and silica-lime content; artificial materials; and synthetic materials.

9. The method according to any one of the preceding claims, wherein the said material reactive to the undesirable anions is in the form of particles such as grains, granules, or beads, or particles with random shapes; preferably, these particles have a size, defined by their largest dimension, such as a diameter, in the case of beads, from 10 nm to 5 cm, preferably from 100 nm to 1 cm, better from 0.1 mm to 2 mm, still better from 0.5 mm to 2 mm, said material reactive to the undesirable anions preferably having a specific surface area from 0.1 to 1,000 m²/g, preferably from 1 to 200 m²/g, still preferably from 10 to 200 m²/g.

10. The method according to any one of the preceding claims, wherein the organic compound mass / solid material reactive to the undesirable anions mass ratio is from 0.01 to 0.5, preferably from 0.025 to 0.25, for example from 0.05 to 0.1.

11. The method according to any one of the preceding claims, wherein the solid material reactive to the undesirable anions is already present in the treated material.

12. The method according to any one of claims 1 to 10, wherein the solid material reactive to the undesirable anions is not already present in the treated material, and it is added to the dense pressurised aqueous medium at subcritical or supercritical state, and/or to the treated material.

13. The method according to any one of claims 1 to 12, wherein the treated material is brought into contact with pressurised water in the subcritical state, at a pressure in the range of more than 2 MPa (20 bar), for example 2.1 MPa (21 bar), up to less than 22.1 MPa (221 bar), for example up to 22 MPa (220 bar), and at a temperature in the range of more than 150°C, for example from 151°C, up to less than 374°C, for example up to 373°C, in particular at a temperature of 250°C, preferably for a time period from 10 to 600 minutes, still preferably from 30 to 600 minutes, better from 120 to 600 minutes.

14. The method according to any one of claims 1 to 12, wherein the treated material is brought into contact with pressurised water in the supercritical state, at a pressure higher than or equal to 22.1 MPa, preferably from 22.1 to 40 MPa, and at a temperature higher than or equal to 374°C, preferably from 374°C to 600°C, still preferably from 400°C to 600°C, for example 400°C, preferably for a time period from 1 to 180 minutes, still preferably from 10 to 180 minutes, better from 20 to 120 minutes.

15. The method according to any one of the preceding claims, wherein said treated material is brought into contact with the dense pressurised aqueous medium at the subcritical or supercritical state, and furthermore in the presence of an oxidising agent, said oxidising agent being preferably selected from among pure oxygen, air and hydrogen peroxide.
